# EUROPÄISCHE PATENTSCHRIFT

(11) **EP 2 982 780 B1**
(45) Veröffentlichungstag und Bekanntmachung des Hinweises auf die Patenterteilung: **11.12.2019**
(21) Anmeldenummer: 14182961.4
(22) Anmeldetag: 29.08.2014
(51) Int. Cl.: C30B 11/00, C30B 29/06, C30B 35/00, C03B 19/09

(54) **VERFAHREN ZUR HERSTELLUNG EINES SILIZIUMBLOCKS, ZUR VERFAHRENSDURCHFÜHRUNG GEEIGNETE KOKILLE AUS QUARZGLAS ODER QUARZGUT SOWIE VERFAHREN FÜR DEREN HERSTELLUNG**
METHOD FOR PREPARING A SILICON BLOCK, MOULD MADE OF QUARTZ GLASS OR QUARTZ SUITABLE FOR THAT METHOD, AND METHOD FOR THE PREPARATION OF SAME
PROCÉDÉ POUR LA FABRICATION D'UN BLOC DE SILICIUM, LINGOTIÈRE EN VERRE DE QUARTZ OU EN QUARTZ APPROPRIÉE POUR CE PROCÉDÉ, ET SON PROCÉDÉ DE FABRICATION

(30) Priorität: 04.08.2014 EP 14179760
(43) Veröffentlichungstag der Anmeldung: 10.02.2016
(73) Patentinhaber: Heraeus Quarzglas GmbH & Co. KG, 63450 Hanau (DE); SolarWorld Innovations GmbH, 09599 Freiberg (DE)
(72) Erfinder: Schenk, Christian, 55218 Ingelheim (DE); Scheich, Gerrit, 63500 Seligenstadt (DE); Nielsen, Nils-Christian, 65388 Schlangenbad (DE); Lehmann, Walter, 04155 Leipzig (DE); Freudenberg, Bernhard, 96450 Coburg (DE); Dadzis, Kaspars, 09599 Freiberg (DE); Nadolny, Sandra, 09599 Freiberg (DE); Wolny, Franziska, 01097 Dresden (DE); Fischer, Gerd, 01809 Dohna (DE)
(74) Vertreter: Staudt, Armin Walter

(56) Entgegenhaltungen:
- EP-A2- 0 949 358
- DE-A1- 10 344 189
- DE-A1- 19 943 103
- DE-B3-102009 049 032
- FR-A1- 2 854 398
- US-A1- 2013 015 318

## Beschreibung

### Technisches Gebiet

Die Erfindung betrifft ein Verfahren zur Herstellung eines Siliziumblocks in einem Kristallzüchtungsprozess für Silizium durch Bereitstellen einer Solarkokille mit einem eine Innenwandung aufweisenden Kokillenbasiskörper aus Quarzglas oder aus Quarzgut, von der mindestens ein Teil von einer SiO₂-haltigen Körnungsschicht bedeckt ist, wobei Silizium in die Solarkokille gefüllt, das Silizium unter Bildung einer Silizium-Schmelze erhitzt und die Silizium-Schmelze unter Kristallisation und Bildung des Siliziumblocks abgekühlt werden.

Weiterhin betrifft die Erfindung eine Solarkokille mit Rechteckform zum Einsatz in einem Kristallzüchtungsprozess, mit einem eine Innenwandung aufweisenden Kokillenbasiskörper aus Quarzglas oder aus Quarzgut sowie einer die Innenwandung mindestens teilweise bedeckenden SiO₂-haltigen Schicht.

Außerdem geht es bei der Erfindung um ein Verfahren zur Herstellung einer So-larkokille mit Rechteckform zum Einsatz in einem Kristallzüchtungsprozess, indem ein eine Innenwandung aufweisender Kokillenbasiskörper aus Quarzglas oder aus Quarzgut sowie eine amorphe SiO₂-Teilchen enthaltende Dispersion bereitgestellt werden, unter Einsatz der Dispersion eine SiO₂-haltige Schlickerschicht mit einer Schichtdicke von mindestens 0,1 mm auf mindestens einem Teil der Innenwandung aufgebracht wird, sowie die Schlickerschicht getrocknet und unter Ausbildung einer Diffusionssperrschicht thermisch verdichtet wird.

### Stand der Technik

Blöcke aus mono- oder polykristallinem Silizium für Solaranwendungen werden nach dem Bridgman- oder dem Vertical Gradient Freeze (VGF)-Verfahren in Solarkokillen aus Quarzglas oder aus Quarzgut erschmolzen.

Diese Solarkokillen werden häufig anhand keramischer Schlickerverfahren hergestellt und haben eine polygonale, im einfachsten Fall rechteckige Tiegelöffnung. Aus Kostengründen werden die Kokillen überwiegend aus natürlich vorkommendem Quarz-Rohstoff erzeugt. Daher ist die Reinheit des Kokillenmaterials grundsätzlich geringer als die von synthetisch erzeugtem Quarzglas. Beim Kristallzüchtungsprozess wird in die Kokillenwandung mindestens teilweise auf Temperaturen oberhalb von 1.410°C aufgeheizt. Die in der Kokillenwandung vorhandenen Verunreinigungen verursachen dabei eine Kristallisation unter Bildung von Cristobalit. Beim Abkühlen führt eine als "Cristobalitsprung" bekannte Gefügeumwandlung zur Zerstörung der Kokille, die somit nur einmal verwendet werden kann.

Der Siliziumblock schrumpft beim Abkühlen stärker als die Kokille. Bei Anhaftungen an der Kokillenwandung kann es zu Spannungen und Rissen im Siliziumblock kommen. Dem wird mit Trennschichten aus Si₃N₄, SiC und dergleichen begegnet.

Darüber hinaus werden metallische Verunreinigungen während der Kristallzüchtung auch aus der Kokillenwandung in das Silizium eingetragen. Der Eintrag erfolgt durch Volumendiffusion, Oberflächendiffusion oder durch Verdampfen flüchtiger Metallverbindungen aus dem Quarzgutscherben, und zwar sowohl in die flüssige Silizium-Phase als auch in die kristallisierte feste Phase. Im Verlaufe der letzten Jahre wurde der Verunreinigungsgehalt ständig reduziert und dabei die Leitverunreinigung Eisen, die stellvertretend auch für andere metallische Verunreinigungen wie beispielsweise Cr oder Cu steht, von etwa 100 auf 10 Gew.-ppm gesenkt werden. Eisen-Verunreinigungen sind jedoch besonders kritisch, da sie die elektronischen Eigenschaften des Halbleitermaterials beeinträchtigen und besonders leicht diffundieren.

Am erstarrten Siliziumblock (auch als "Ingot" bezeichnet) wird daher in der Randzone ein Bereich mit erhöhter Fe-Gesamtkonzentration gefunden. Diese liegt typischerweise im Bereich von 10¹⁴ bis 10¹⁶ at/cm³. In ungünstigen Fällen stellt die Randzone Materialverlust dar, der maßgelblich zu den Fertigungskosten für Solarzellen beiträgt. (Hinweis: in der Literatur werden häufig Konzentrationsangaben nur für das im Siliziumgitter interstitiell gelöste Eisen genannt, die obigen Angaben beziehen sich jedoch auf die Gesamt-Konzentration an Eisen).

Aus den verschlechterten elektrischen Eigenschaften im Randbereich kann auf die Verunreinigung geschlossen werden. Bei der Messung mittels der Minoritätsträger-Ladungsträgerlebensdauer (LTLD) wird der schlechte Bereich rot dargestellt und deshalb auch als "red zone" bezeichnet. In der prozessierten Zelle werden anhand der Photolumineszenz-Messung (PL) Randbereiche mit reduziertem elektrischem Zellwirkungsgrad detektiert und sind als dunkle Bereiche erkennbar.

Um den Eintrag von Verunreinigungen aus der Tiegelwandung zu reduzieren, wird die Kokillen-Innenwandung mit Diffusionsbarrieren versehen. Hierfür ist eine Vielzahl von Methoden bekannt.

So wird in der DE 10 2011 082 628 A1 vorgeschlagen, den Boden und die Seitenwände der Kokille mit einer Diffusionsbarriere in Form eingelegter Platten aus hochreinem Quarzglas mit Dicken von beispielsweise 1 mm auszukleiden. Die Quarzglas-Platten können innen zusätzlich mit einer Si₃N₄-Schicht versehen sein, um die Entnahme des Silizium-Blocks zu vereinfachen.

Zwischen den einzelnen Platten und im Randbereich bleiben offene Spalte, die abgedichtet werden müssen. Durch Unebenheiten der Kokille und Punktlasten nach der Silizium-Befüllung besteht hohe Bruchgefahr für die Platten. Bei unterschiedlichen Auflagespaltweiten ergeben sich undefinierte Wärmeübergänge. Zudem sind Platten aus hochreinem Quarzglas sehr teuer. Hohe Materialkosten und der Montageaufwand machen den Fertigungsprozess kostenaufwändig, insbesondere für die Abdeckung großvolumiger Kokillen mit Breiten von mehr als 0,5 m und Wandhöhen von 0,25 m und mehr.

In der EP 0 949 358 A2 wird zur Herstellung einer Kokille ein Verfahren vorgeschlagen, bei dem ein Wachskern in Form der Kokillen-Innenwand bereitgestellt und darauf eine Schlickerschicht durch Tauchen aufgebracht wird, die feinkörnige SiO₂-Teilchen mit Teilchengrößen 40 µm sowie kolloidales SiO₂ enthält. Auf die Schlickerschicht wird feinkörniger Quarzglassand (fine fused silica sand) hoher Reinheit mit Teilchengrößen um 150 µm aufgepudert. Das Eintauchen und Abpudern wird bis um Erreichen einer Schichtdicke von 3 mm wiederholt. Nach erneutem Eintauchen in den Schlicker wird grobkörniger Quarzglassand mit Teilchengrößen zwischen 500 und 1500 µm geringerer Reinheit aufgepudert. Auch dieser Vorgang wird widerholt, bis eine Schichtdicke von 8 mm erreicht ist. Der so erzeugte Schichtverbund aus innerer Lage und äußerer Lage wird nach dem Ausschmelzen des Wachskerns bei einer Temperatur von 800 °C während 2 Stunden verbacken. Beim Kristallzüchtungsprozess kommt nur die innere Lage in Kontakt mit dem Silizium, haftet beim Abkühlen an dem Siliziumblock und delaminiert von der äußeren Lage. Dadurch wird die Ausbildung mechanischer Spannungen im Siliziumblock vermieden.

Ein ähnliches Verfahren ist auch aus der WO 2005/106084 A1 bekannt. Darin wird eine Beschichtung des Bodens und der Innenwände eines Solarkokillen-Basiskörpers mit einer wässrigen Aufschlämmung beschrieben, die SiO₂-Partikel unterschiedlicher Größen enthält. Die SiO₂-Schicht hat eine Dicke von bis zu 500 µm und dient als Zwischenschicht. Die eigentliche Oberflächenschicht besteht aus Si₃N₄. Die Haftung der SiO₂-Zwischenschicht am Basiskörper wird absichtlich gering gehalten, damit sie beim Abkühlen delaminiert und der Siliziumblock unbeschädigt und möglichst spannungsfrei bleibt. Die geringe Haftung der Zwischenschicht wird erzeugt, indem ihr eine gewisse Porosität aufgeprägt wird.

Die DE 10 2009 049032 B3 beschreibt ein Verfahren zur Herstellung eines beschichteten Bauteils aus Quarzglas - beispielsweise eines Tiegels - durch Aufsprühen eines SiO₂-Schlickers. Dieser enthält eine Grobfraktion von SiO₂-Teilchengrößen im Bereich zwischen 1 µm bis 50 µm in Form amorpher splittriger und sphärischer SiO₂-Teilchen sowie SiO₂-Nanoteilchen mit einem Gewichtsanteil im Bereich von 0,2 bis 10 Gew.-%. Der Feststoffgehalt liegt zwischen 74 bis 78 Gew.-%. Die Teilchen bestehen zu mindestens 99,99 Gew.-% aus SiO₂.

Die US 5,053,359 A beschreibt eine gesinterte Kokille aus hochreinem, amorphem SiO₂-Pulver, dem ein Kristallisationspromotor in Form von Aluminiumoxid zudotiert ist. Der Aluminiumoxid-Zusatz bewirkt eine Kristallisation der Tiegelwandung während des Schmelzprozesses. Zusätze an Kristallisationspromotoren werden auch für glasig im Lichtbogenprozess geschmolzene Quarzglastiegel beschrieben, beispielsweise in der WO 2007/063996 A1. Die Kristallbildung dient in erster Linie der Steigerung der Temperaturstabilität. Es wird auch erwähnt, dass Kontaminationen aus der Tiegelwandung dadurch reduziert werden können.

### Technische Aufgabenstellung

Das zuletzt genannte Patent betrifft einen Quarzglastiegel für den Kristallziehprozess nach dem Czochralski-Verfahren. Die dabei eingesetzten Tiegel sind rotationssymmetrisch und werden in einem Lichtbogenprozess erschmolzen. Im Anschluss an die Herstellung des Basiskörpers wird dabei häufig auf der Innenseite zusätzlich eine dünne Innenschicht aus hochreinem SiO₂ thermisch aufgetragen, um die Oberflächenqualität zu verbessern. Wegen ihres polygonalen Innenquerschnitts ist der Lichtbogenschmelzprozess für Solarkokillen jedoch nicht geeignet.

Solarkokillen werden typischerweise durch Sintern in einem Sinterofen verfestigt. Beim Sintern besteht jedoch die Gefahr, dass sich die Sintervorgänge zur Verdichtung der Kokillenwandung und etwaige Kristallisationsvorgänge überlagern, so dass die Verdichtung der Kokillenwandung behindert wird und eine Restporosität im Gefüge bestehen bleibt. Bei einem porösen Gefüge können Verunreinigungen jedoch besonders leicht in das Schmelzgut gelangen.

Diese Problematik stellt sich grundsätzlich auch beim Sintern der unter Einsatz von partikelförmigem Ausgangsmaterial erzeugten Diffusionssperrschichten gemäß dem oben erläuterten Stand der Technik, insbesondere, wenn diese erst während des Kristallzüchtungsprozesses thermisch verdichtet werden, so ist nicht nur zu gewährleisten, dass eine ausreichend dichte Schicht entsteht, sondern auch dass während der Aufheizphase und der frühen Schmelzphase möglichste wenig an Verunreinigungen aus der der Kokillenwandung in die Schmelze gelangt.

Diese Bedingungen sind nicht einfach zu erfüllen, so dass Zellen aus dem Randbereich von Siliziumblöcken häufig immer noch einen dunklen Zell-Rand, also eine Zone mit reduziertem Wirkungsgrad zeigen, wenn dieser durch Photolumineszenzmessung sichtbar gemacht wird.

Der Erfindung liegt daher die Aufgabe zugrunde, ein Verfahren anzugeben, das eine kostengünstige Fertigung eines Siliziumblocks mit geringem Materialverlust ermöglicht.

Weiterhin liegt der Erfindung die Aufgabe zugrunde, eine Solarkokille bereitzustellen, die diese Anforderung zuverlässig erfüllt.

Darüber hinaus liegt der Erfindung die Aufgabe zugrunde, ein kostengünstiges Verfahren zur Herstellung einer solchen Solarkokille zur Verfügung zu stellen.

### Allgemeine Beschreibung der Erfindung

Hinsichtlich des Verfahrens zur Herstellung der Kokille unter Einsatz einer amorphe SiO₂-Teilchen enthaltenden Dispersion wird diese Aufgabe ausgehend von einem Verfahren der eingangs genannten Gattung erfindungsgemäß dadurch gelöst,
(a) dass die Dispersion eine Dispersionsflüssigkeit und amorphe SiO₂-Teilchen enthält, die eine Grobfraktion mit Teilchengrößen im Bereich zwischen 1 µm bis 50 µm sowie eine Feinfraktion mit SiO₂-Nanoteilchen mit Teilchengrößen von weniger als 100 nm bilden,
   - wobei der Gewichtsanteil der SiO₂-Nanoteilchen bezogen auf den Feststoffgehalt der Dispersion im Bereich zwischen 2 und 15 Gew.-% beträgt, und
   - wobei die Feinfraktion aus SiO₂-Nanoteilchen mit Teilchengrößen von weniger als 100 nm einen Volumenanteil einer Gießhaut von mehr als 70 % ausmachen,
(b) und dass die SiO₂-haltige Körnungsschicht erst beim Aufheizen des Siliziums während des Kristallzüchtungsprozesses thermisch zu der Diffusionssperrschicht verdichtet wird.

Aus den oben erläuterten Gründen, insbesondere wegen der Kristallisationsneigung des Kokillenbasiskörpers und den zur Verdichtung notwendigen hohen Temperaturen, stößt die Herstellung einer dichten Diffusionssperrschicht aus SiO₂-haltiger vor dem bestimmungsgemäßen Einsatz der Kokille auf Schwierigkeiten. Beim erfindungsgemäßen Verfahren wird die SiO₂-haltige Körnungsschicht erst beim Kristallzüchtungsprozess thermisch zu der Diffusionssperrschicht verdichtet.

Somit besteht eine besondere Herausforderung des erfindungsgemäßen Verfahrens darin, eine möglichst verunreinigungsfreie SiO₂-haltige Körnungsschicht bereitzustellen, die beim Aufheizen beim Kristallzüchtungsprozess schnell zu einer möglichst dichten Diffusionssperrschicht verdichtbar ist. Beim Aufheizen des Siliziums im Kristallzüchtungsprozess erreicht die Kokillenwandung Temperaturen, die den Bereich zwischen 1.370 °C und 1.450 °C umfassen. Die Maximaltemperatur an der Kokillenwand liegt üblicherweise knapp oberhalb der Schmelztemperatur von Silizium; im Bodenbereich der Kokille kann sie aber auch niedriger sein.

Vorteilhaft bei dieser Vorgehensweise ist die Vermeidung der thermischen Beanspruchung des Kokillenbasiskörpers, der dabei kristallisieren und Risse bilden könnte. Insbesondere können abkühlungsbedingte Risse im Anschluss an etwaige thermische Beschichtungsprozesse entstehen. Daher hat die Ausbildung der dichten Diffusionssperrschicht während des Silizium-Schmelzprozesses den Vorteil, dass sie ohne Bildung von Rissen entsteht. Das Sintern der Grünschicht beginnt bereits bei relativ geringen Temperaturen; es wird zunächst eine noch offenporige Sinterschicht erhalten. Eine merkliche Verdichtung, die zu einer geschlossenporigen Ausbildung der Sinterschicht führt, setzt oberhalb des Transformationsbereiches ein, der je nach Art des Quarzglases der Körnungsschicht im Temperaturbereich von 1.000 bis etwa 1.200°C liegt. Die verdichtete Sinterschicht entspricht der Diffusionssperrschicht; sie kann thermisch eingebrachte Spannungen relaxieren und damit einer Rissbildung entgegenwirken. Voraussetzung dafür ist, dass die Diffusionssperrschicht glasig-amorph ist und nicht kristallisiert. Bei Erreichen der Schmelztemperatur für Silizium (1.410°C) erreicht die glasigamorphe verdichtete Sinterschicht eine Viskosität (in der Größenordnung 10¹⁰ dPas), bei der eine merkliche plastische Verformbarkeit gegeben ist.

Um die "red zone" im Siliziumblock signifikant zu reduzieren, werden geringe Eisengehalte von weniger als 2 Gew.-ppm, vorzugsweise weniger als 0,5 Gew.-ppm, benötigt. Es hat sich gezeigt, dass dafür nicht nur eine dichte Diffusionssperrschicht erforderlich ist, sondern dass die Dichtigkeit der Diffusionssperrschicht beim Aufheizen der Silizium-Charge auch möglichst rasch gegeben sein muss, das heißt, möglichst vor Erreichen der Maximaltemperatur im Kristallzüchtungsprozess.

Sinterhilfsmittel oder Bindemittel könnten zwar zu einem raschen Versintern der Körnungsschicht beitragen, würden jedoch gleichzeitig Verunreinigungen in die Schlickerschicht eintragen und somit die Kristallisationsneigung der Schicht fördern und sind daher ungeeignet. Um dennoch eine schnelle und zuverlässige Verdichtung der Diffusionssperrschicht zu erreichen, sieht die Erfindung eine besonders sinteraktive Körnungsschicht vor. Ihre hohe Sinteraktivität wird durch eine mehrmodale Korngrößenverteilung erreicht, bei der amorphe SiO₂-Teilchen mit Teilchengrößen im Bereich zwischen 1 µm bis 50 µm (Grobfraktion) sowie SiO₂-Nanoteilchen (Feinfraktion) mit einem Gewichtsanteil zwischen 2 bis 15 Gew.-% vorgesehen sind.

Die Sinterfähigkeit der Körnungsschicht hängt insbesondere von der Zusammensetzung der Schlickerschicht im oberflächennahen Bereich ab. Entscheidend sind dabei die Verteilung und der Anteil an SiO₂-Nanoteilchen. Bei einem hohen Anteil ergibt sich eine höhere Sinteraktivität, die ein thermisches Verdichten bei vergleichsweise niedriger Temperatur oder kurzer Sinterdauer zu einem Glas mit höherer Dichte und geringer Porosität ermöglicht. Im Idealfall finden sich im oberflächennahen Bereich der Schlickerschicht nur relativ feine SiO₂-Teilchen.

Um dem nahe zu kommen, kann der Schlickerschicht beispielsweise während des Trocknungsvorgangs ausreichend Gelegenheit zur Entmischung gegeben werden. Die Entmischung bewirkt innerhalb der erzeugten Schlickerschicht eine Zweiteilung in einen an die Kokillen-Innenwandung angrenzenden, unteren Bereich, in dem vorwiegend der Grobanteil der SiO₂-Teilchen zu finden ist, und in einen an die freie Oberfläche der Schicht angrenzenden Außenbereich, in dem die Feinfraktion angereichert ist. Die Feinfraktion der SiO₂-Teilchen wird von Nanoteilchen gebildet. Nanoteilchen bestehen typischerweise aus einem Verbund einiger Tausend SiO₂-Moleküle und haben üblicherweise eine spezifische Oberfläche nach BET im Bereich von 50 bis 400 m²/g. Im Unterschied zu dem eingangs erläuterten Verfahren gemäß der EP 0 949 358 A2, bei dem mehrere Schichtlagen erzeugt werden, genügt beim erfindungsgemäßen Verfahren ein einziger Schichtauftrag; die Trennung der Teilchen unterschiedlicher Teilchengrößen erfolgt hier durch Entmischung und andere physikalische Effekte, die im Folgenden noch näher erläutert werden.

Innerhalb der Schlickerschicht bildet sich bald nach dem Auftragen auf die Kokillen-Innenwandung eine inhomogene Teilchengrößenverteilung aus, wobei der Übergang zwischen unterem und oberem Bereich in der Grünschicht bei mikroskopischer Betrachtung eine erkennbare Ausprägung hat (als Grünschicht wird die getrocknete Schlickerschicht bezeichnet). Entscheidende Parameter für das Gelingen dieser Entmischung sind:
- Der anfängliche Flüssigkeitsgehalt des Schlickers - dieser sollte ausreichend hoch sein, vorzugsweise mindestens 20 Gew.-%, um eine hinreichende Beweglichkeit der SiO₂-Nanoteilchen innerhalb der Schlickerschicht zu gewährleisten.
- Die Art und Weise, wie die Schlickerschicht aufgebracht wird. Diese wird vorzugsweise nicht sukzessive in mehreren Lagen aufgebaut, wie etwa beim Aufsprühen der Schlickerschicht, sondern in einem Arbeitsgang erzeugt, bevorzugt durch Aufgießen oder Aufspritzen und mit einer Mindestdicke von 0,1 mm, vorzugsweise einer Mindestdicke von 0,3 mm. Dadurch wird zum einen ein hinreichend großes Reservoir an SiO₂-Nanoteilchen zur Verfügung gestellt und zum anderen wird ein zu schnelles Trocknen der Schicht verhindert, das einer ausreichenden Entmischung entgegenwirken kann. Beim Auftragen der Schicht durch Aufgießen oder Aufspritzen erfolgt der Schlickerauftrag entweder als kontinuierlicher Strahl, also ohne Zerteilung in einzelne Tropfen, oder mit einem so geringen Zerteilungsimpuls, dass eine Verkleinerung des Tropfendurchmessers des Schlickers unter seine Gleichgewichtsgröße vermieden wird; sie liegt bei mindestens 1 mm. Daher kommt es zu keiner nennenswerten Verringerung des Flüssigkeitsgehalts des Schlickers beim Auftragen der Schlickerschicht. Die Schlickerschicht erhält dabei vorzugsweise ihre Endform unter Einwirkung eines Werkzeugs, wie etwa einer Rakel, einem Pinsel, einer Aufspritzdüse oder einem Spachtel. Durch streichende Einwirkung des Bearbeitungswerkzeugs wird die Schichtoberfläche etwas flüssiger, was das Anreichern von SiO₂-Nanoteilchen auch bei verhältnismäßig geringem Flüssigkeitsgehalt erleichtert. In dem Zusammenhang zeigt die Sprühbeschichtung gegenüber dem Aufgießen oder Aufspritzen einen weiteren Nachteil, da es infolge des mechanischen Impulses beim Sprühen durch Ausbildung von Suspensionstropfen mit geringen Tropfendurchmessern kommt, bei denen das Trocknen unweigerlich bereits in der Flugphase in nennenswerten Umfang einsetzt. Der Flüssigkeitsgehalt der durch Sprühen gebildeten Schlickerschicht unterscheidet sich daher merklich von demjenigen des Ausgangsschlickers. Der Flüssigkeitsverlust kann durch Erhöhen des anfänglichen Flüssigkeitsgehalts wegen dann zunehmender Entmischungstendenz nicht ohne weiteres kompensiert werden.
- Ein Anteil an SiO₂-Nanoteilchen, der hoch genug ist, um eine nennenswerte Anreicherung im Außenbereich der Schlickerschicht bewirken zu können - dieser liegt im Schlicker im Bereich von 2 bis 15 Gew.-% und bevorzugt bei weniger als 10 Gew.-%. Im Gegensatz zur Sprühschicht, die sich durch eine weitgehend homogene Verteilung der Teilchengrößen über die Schichtdicke auszeichnet, ist die Schlickerschicht vorzugsweise inhomogen, indem sie einen inhomogenen, nicht konstanten Verlauf der Teilchengrößenverteilung über die Schichtdicke zeigt, mit einer Anreicherung von SiO₂-Nanoteilchen im oberflächennahen Bereich. In der keramischen Verfahrenstechnik werden derartige oberflächennahe Bereiche auch als "Gießhaut" bezeichnet und häufig als Hinweis für eine unerwünschte Inhomogenität der Schlickerschicht betrachtet und in der Regel entfernt. Infolge dieser Anreicherung kann die Grünschicht jedoch leichter und schneller dichtgesintert werden als ohne sie. Das heißt, zum Dichtsintern sind eine geringere Sintertemperatur und/oder eine verkürzte Sinterdauer erforderlich als bei einer Schlickerschicht mit homogener Teilchengrößenverteilung. Bei sehr hohen Anteilen an SiO₂-Nanoteilchen wird eine Tendenz zur Rissbildung beim Trocknen oder Sintern beobachtet.
- Die Art und Weise, wie die Dispersionsflüssigkeit entfernt wird - dies erfolgt vorzugsweise langsam und gezielt in Richtung der freien Oberfläche, so dass die entweichende Flüssigkeit SiO₂-Nanoteilchen nach oben in den Außenbereich mitnehmen kann. Bevorzugt wird die Schlickerschicht getrocknet, indem die Dispersionsflüssigkeit mit einer Rate und in einer Richtung abgezogen wird, derart, dass unter Wirkung der abziehenden Dispersionsflüssigkeit die Feinfraktion im Außenbereich der Schlickerschicht angereichert wird und dabei eine "Gießhaut" bildet, wie sie nachfolgend noch näher definiert wird.

Dadurch wird innerhalb der Schlickerschicht ein besonders homogener, dichter und sinteraktiver oberflächennaher Volumenbereich mit einem relativ hohen Anteil an SiO₂-Nanoteilchen erzeugt, wobei der Anteil höher als der mittlere Anteil der SiO₂-Nanoteilchen in der Schlickerschicht ist.

Das Anreichern der feineren SiO₂-Teilchen und insbesondere der Feinfraktion an der Oberfläche der Schlickerschicht ist visuell als Hautbildung erkennbar, was hier auch als "Gießhaut" bezeichnet wird. Die Schlickerschicht wirkt visuell gegebenenfalls wie von einer Wachsschicht überzogen.

Die Gießhaut ist auch nach dem Trocknen (in der Grünschicht) erkennbar. Als Gießhaut wird dabei derjenige Oberflächenbereich der Grünschicht verstanden, der eine geringe Porosität aufweist. Die Dicke dieser Haut liegt bevorzugt im Bereich von 3 bis 15 µm, besonders bevorzugt im Bereich von 5 bis 10 µm. Weiterhin zeichnet sich die Gießhaut dadurch aus, dass die Feinfraktion aus SiO₂-Nanoteilchen mit Teilchengrößen von weniger als 100 nm einen Volumenanteil der Gießhaut von mehr als 70 %, bevorzugt einen Volumenanteil von mehr als 80 % ausmachen.

Die SiO₂-Nanoteilchen liegen in der Gießhaut in der Regel nicht vereinzelt, sondern in Form von Aggregaten oder Agglomeraten vor, die die wenigen SiO₂-Teilchen der Grobfraktion teilweise oder vollständig einbetten. Da die Porosität der Gießhaut gering ist, entspricht der Volumenanteil ungefähr dem Gewichtsanteil der SiO₂-Nanoteilchen. Ein Volumenanteil von mehr als 70 % in der Gießhaut entspricht demnach einer Anreicherung um mehr als dem10-fachen gegenüber einem typischen Ausgangs-Schlicker mit einem mittleren Gewichtsanteil von etwa 7 % oder weniger an SiO₂-Nanoteilchen.

Es hat sich gezeigt, dass eine derartige Schlickerschicht reproduzierbar und bei mäßigen Sinterbedingungen (das heißt: vergleichsweise niedrige Sintertemperatur und/oder kurze Sinterdauer) zu einer dichten, transparenten Quarzglasschicht mit verhältnismäßig geringer Oberflächenrauigkeit gesintert werden kann. Diese mäßigen Sinterbedingungen sind beim bestimmungsgemäßen Einsatz der Kokille beim Erhitzen der Silizium-Charge regelmäßig erfüllt, bevor die Maximaltemperatur im Kristallzüchtungsprozess, beispielsweise die Schmelztemperatur des Siliziums (etwa 1.410 °C), erreicht ist. Dabei verbleibt im Bereich der ehemaligen Gießhaut eine geringe geschlossene Porosität von vorzugsweise maximal 10 %. Es hat sich gezeigt, dass bereits eine derart dünne aber dichte Oberflächenschicht eine wirksame Diffusionsbarriere insbesondere für Eisen darstellt.

Bekanntlich zeigen SiO₂-Nanoteilchen zwar eine hohe Sinteraktivität, was die vergleichsweise niedrige Sintertemperatur erklärt, andererseits bewirken sie in hoher Konzentration jedoch auch eine hohe Trockenschwindung, und zwar in lateraler Richtung (in der Schichtebene) und können so zu Delamination der Schicht und zu Rissbildung führen. Dass diese Effekte beim erfindungsgemäßen Verfahren nicht auftreten, kann mit einer guten Verzahnung zwischen Gießhaut und übriger Grünschicht durch die größeren SiO₂-Teilchen erklärt werden.

Das endgültige Verdichten der Schlickerschicht (beziehungsweise der Grünschicht) erst beim bestimmungsgemäßen Einsatz der Kokille vereinfacht den Fertigungsprozess und erspart einen ansonsten erforderlichen Heißbearbeitungsprozess. Dies schließt nicht grundsätzlich eine thermische Behandlung der Grünschicht bei einer Temperatur unterhalb der Maximaltemperatur im Kristallzüchtungsprozess aus, bei der auch eine gewisse Verdichtung erfolgen kann, wie etwa zum Sintern der Kokillenwandung bei einer Temperatur unterhalb der Cristobalit-Bildungstemperatur oder zum Einbrennen einer Oberflächenschicht aus Si₃N₄, was typischerweise unterhalb 1.200 °C erfolgt. Allerdings kann ein mehrfaches Aufheizen der Grünschicht auf hohe Temperaturen zu unerwünschten Wechselwirkungen mit angrenzenden Schichtbereichen führen, so dass diese Verfahrensweise grundsätzlich nicht vorteilhaft ist.

Es hat sich gezeigt, dass bei Einsatz einer erfindungsgemäß hergestellten Kokille zur Herstellung eines Siliziumblocks in einem Bridgeman- oder VGF-Prozess "red zone" und dunkler Zell-Rand deutlich reduziert beziehungsweise vermieden werden.

Die Sinteraktivität der Schlickerschicht beziehungsweise der Grünschicht kann weiter erhöht werden, wenn SiO₂-Körnung aus synthetisch erzeugtem Quarzglas eingesetzt wird, das einen Hydroxylgruppengehalt von mindestens 50 Gew.-ppm aufweist.

Amorphe synthetische SiO₂ Körnung zeichnet sich durch hohe Reinheit aus und sie zeigt eine niedrigere Viskosität bei gleicher Temperatur im Vergleich zu amorpher SiO₂-Körnung, die aus natürlich vorkommendem Quarzrohstoff erzeugt worden ist. Der zu höheren Temperaturen verschobene Viskositätsbereich natürlicher SiO₂-Körnungen ist zum Teil auf das typischerweise darin enthaltene Aluminiumoxid zurückzuführen. Synthetische SiO₂-Körnung ist weitgehend frei von Aluminiumoxid. Hydroxylgruppen (OH-Gruppen) verringern hingegen zusätzlich die Viskosität von Quarzglas. Durch Einsatz von OH-haltiger SiO₂-Körnung verschiebt sich der Viskositätsverlauf somit weiter zu niedrigeren Temperaturen. Dadurch setzt der Sintervorgang und damit auch die Verdichtung der Schicht bei vergleichsweise niedrigeren Temperaturen sein.

Der SiO₂-Gehalt der amorphen SiO₂-Teilchen beträgt vorzugsweise mindestens 99,99 Gew.-%. Der Feststoffanteil des unter Einsatz derartiger SiO₂-Partikel hergestellten Schlickers besteht somit zu mindestens 99,99 Gew.-% aus SiO₂. Bindemittel oder andere Zusatzstoffe sind nicht vorgesehen. Der Gesamt-Gehalt an metallischen Verunreinigungen der Übergangselemente beträgt vorzugsweise weniger als 5 Gew.-ppm, besonders bevorzugt weniger als 2,5 Gew.-ppm und der Gehalt an Eisen beträgt weniger als 2 Gew.-ppm, bevorzugt weniger als 1 Gew.-ppm und besonders bevorzugt weniger als 0,5 Gew.-ppm. Eine Kontaminations- oder Kristallisationsgefahr geht von diesem Ausgangsmaterial nicht aus. Der Cristobalit-Anteil in der getrockneten SiO₂-Schlickerschicht (=Grünschicht) sollte höchstens 1 Gew.-% betragen, da es andernfalls beim Sintern zur Kristallisation der Grünschicht kommen kann, was eine Verdichtung verhindern und zum Ausschuss der Kokille führen kann.

Je geringer der Eisengehalt der SiO₂-Körnung ist, umso geringer ist die Kristallisationsneigung der Körnungsschicht beim Sintern und umso niedriger ist der Eintrag in die Siliziumschmelze. Der Gesamt-Eisengehalt der Körnung liegt daher bevorzugt bei weniger als 2 Gew.-ppm, bevorzugt weniger als 1 Gew.-ppm und besonders bevorzugt bei weniger als 0,5 Gew.-ppm.

Die Dispersionsflüssigkeit beruht vorzugsweise auf wässriger Basis. Die polare Natur der wässrigen Phase kann sich auf die Wechselwirkung der SiO₂-Teilchen vorteilhaft auswirken.

Es hat sich als vorteilhaft erwiesen, wenn der Feststoffgehalt der Dispersion bei weniger als 80 Gew.-%, vorzugsweise im Bereich zwischen 70 bis 80 Gew.-% und ganz besonders bevorzugt zwischen 74 und 78 Gew.-% liegt.

Hierbei handelt es sich um einen relativ geringen Feststoffgehalt, wie er beispielsweise für Sprühschlicker typisch ist. Die Sprühfähigkeit erfordert eine niedrige Viskosität und damit einen niedrigen Feststoffgehalt. Andererseits ist ein so geringer Feststoffgehalt an und für sich unerwünscht, weil er zu einer höheren Schwindung der Schlickerschicht und zu Rissbildung führen kann. Der geringe Feststoffgehalt erleichtert jedoch den Transport von SiO₂-Nanoteilchen in den Außenbereich der Schlickerschicht, so dass er beim erfindungsgemäßen Verfahren bevorzugt wird, selbst wenn die Dispersion nicht als Sprühschlicker eingesetzt wird, sondern eine andere Auftragstechnik angewandt wird, wie etwa Aufstreichen oder Aufrakeln auf die Kokillen-Innenwandung, was an und für sich den Einsatz einer Dispersion mit höheren Feststoffgehalten erlauben würde.

Neben der Zusammensetzung der Schlickerschicht ist das Entfernen der Dispersionsflüssigkeit ein wichtiger Parameter zur Ausbildung einer dichten Gießhaut. In dem Zusammenhang ist bevorzugt eine Maßnahme vorgesehen, die bewirkt, dass die Schlickerschicht langsamer trocknet als ohne die Maßnahme.

Ein verlangsamtes Trocknen kann im einfachsten Fall dadurch erreicht werden, dass das Trocknen in einer Umgebung mit einer gegenüber dem Standard erhöhten Feuchtigkeit oder bei vergleichsweise geringer Temperatur geschieht. Häufig wird zum Trocknen die Temperatur des Substrats erhöht, beispielsweise auf mehr als 100 °C; diese Temperaturerhöhung kann hier entfallen. Zum Gewährleisten einer ausreichenden Entmischung der SiO₂-Nanotteilchen an der Oberfläche und zur Ausbildung einer Gießhaut hat sich eine anfängliche Trocknungsdauer von mindestens 2 Minuten, vorzugsweise mindestens 3 Minuten besonders bewährt.

Im einfachsten Fall ist der Kokillenbasiskörper eine handelsübliche Solarkokille aus porösem Quarzglas oder porösem Quarzgut mittlerer Reinheit. In der Regel ist die zu beschichtende Kokillen-Wandung daher porös und saugfähig. In diesem Fall ist ein Befeuchten vor dem Aufbringen der Dispersion hilfreich, wenn eine Verringerung der Trocknungsgeschwindigkeit erreicht werden soll. Das vorherige Befeuchten trägt in dem Fall auch dazu bei, offene oder geschlossene Poren vorab mit Flüssigkeit aufzufüllen, so dass deren Saugeffekt beim anschließenden Aufbringen der Schlickerschicht reduziert ist. Denn der Entzug der Dispersionsflüssigkeit soll möglichst vollständig in Richtung der freien Oberfläche erfolgen, damit SiO₂-Nanoteilchen von der Flüssigkeit in diese Richtung mitgenommen werden können. Bei einem Saugeffekt infolge von Poren würden SiO₂-Nanoteilchen in umgekehrter Richtung abtransportiert. Deswegen ist die denkbare Alternative, nämlich ein Erhöhen des Flüssigkeitsanteils der Dispersion zum Ausgleich des Saugeffektes eher unwirksam und könnte außerdem wegen sehr hohem Flüssigkeitsanteil zur Instabilität der Dispersion führen. Die Flüssigkeit zum Befeuchten der Beschichtungsfläche ist die Dispersionsflüssigkeit oder eine andere Flüssigkeit. Die poröse Beschichtungsfläche ergibt sich beispielsweise aufgrund der Porosität des Kokillenbasiskörpers oder aufgrund der Porosität einer Oberflächenschicht des Kokillenbasiskörpers.

Der saugfähige Kokillenbasiskörper führt zu einem besonders innigen Verbund mit der Schlickerschicht und der daraus zu erzeugenden Diffusionssperrschicht. Dadurch erleichtert die Auftragung einer gleichmäßig dicken Schlickerschicht, insbesondere auch an Ecken und Kanten und trägt zu einem homogenen Wärmeübergang auf der gesamten Kokillenfläche bei.

Es hat sich auch als günstig erweisen, wenn die Schlickerschicht mechanisch verdichtet wird. Das Verdichten kann unmittelbar beim Auftragen der Schlickerschicht erfolgen. Geeignete Methoden erzeugen in der Schicht Druck- oder Scherkräfte, wie beispielsweise Streichen oder Rakeln. Beim mechanischen Verdichten wird das vorhandene Lückenvolumen zwischen den SiO₂-Teilchen verkleinert und die darin vorhandene Dispersionsflüssigkeit wird herausgepresst und sammelt sich an der freien Oberfläche an. Bei diesem Vorgang kann sie SiO₂-Nanoteilchen mitreißen und zur Oberfläche der Schlickerschicht transportieren. Dadurch bildet sich an der Oberfläche ein Flüssigkeitsfilm, der SiO₂-Nanoteilchen enthält und der beim Abtrocknen leicht eine Gießhaut bildet. Darüber hinaus ergibt sich durch das mechanische Verdichten auch ein engerer Kontakt der SiO₂-Teilchen untereinander, was eine höhere Grünfestigkeit der Schlickerschicht nach dem Trocknen und eine bessere Verzahnung mit der Kokillen-Innenwandung bewirkt. Die nach dem Trocknen der Schlickerschicht verbleibende Porosität beträgt vorzugsweise weniger als 15%.

Es hat sich bewährt, wenn die Schlickerschicht mit einer Schichtstärke von maximal 3 mm, vorzugsweise maximal 1,5 mm erzeugt wird.

Bei Schichtdicken der Schlickerschicht von mehr als 3 mm - ebenso wie bei hohen Gewichtsanteilen an SiO₂-Nanoteilchen von mehr als 10% - steigt das Risiko von Schwindungsrissen beim Trocknen und Sintern. Dies kann damit erklärt werden, dass es zur Vermeidung von Rissbildung auf eine gewisse Durchdringung der Grünschicht mit gröberen SiO₂-Teilchen ankommt, die zur Verzahnung der Gießhaut beitragen und so einem Reißen beim Trocknen oder Sintern entgegenwirken. Daher liegt die bevorzugte Dicke der Schlickerschicht nicht wesentlich höher als der D₅₀-Wert der Teilchengrößenverteilung im Grobanteil der SiO₂-Teilchen. Die nach dem Trocknen der Schlickerschicht zur Grünschicht erhaltenen Schichtdicken liegen vorteilhafterweise im Bereich von 0,1 bis 1,5 mm, bevorzugt im Bereich von 0,5 bis 1,5 mm und besonders bevorzugt im Bereich von 0,7 bis 1 mm.

Bevorzugt ist die Grobfraktion splittrige, amorphe SiO₂-Körnung mit einer Korngrößenverteilung mit einem D₅₀-Wert im Bereich zwischen 3 µm und 30 µm.

Die splittrige SiO₂-Körnung trägt zur Integrität der Schlickerschicht und zur Verzahnung mit der Oberfläche bei und verbessert deren Haftung. Die Wirkung hinsichtlich Verzahnung und Haftverbesserung wird am besten bei einer spezifischen Korngrößenverteilung erreicht, die einen D₅₀-Wert zwischen 3 µm und 30 µm hat. Bei einem D₅₀-Wert von weniger als 3 µm ergibt sich nennenswert erhöhte Trockenschwindung der Schlickerschicht, und Körnung mit einem D₅₀-Wert von mehr als 30 µm wirkt einer hohen Feststoffdichte im Schlicker entgegen, was ebenfalls zu einer erhöhten Trockenschwindung beiträgt. Die splittrige Körnung wird am einfachsten durch Mahlen hergestellt, vorzugsweise durch Nassmahlen.

Vorzugsweise wird eine Dispersion eingesetzt, die frei von Bindemitteln ist.

Durch die Bindemittelfreiheit wird der Eintrag von Verunreinigungen in den Schlicker vermieden. Das Sintern erfolgt vorzugsweise ohne Zuhilfenahme von Sinterhilfsmitteln. Die so erzeugten Schichten zeichnen sich durch hohe Reinheit aus. Es werden SiO₂-Gehalte von mehr als 99,99% erreicht. Vor allem Alkalielemente, die entweder als Bestandteil oder auch als Verunreinigungen in den Binderzusätzen vorkommen können, führen bei erhöhten Temperaturen zur Bildung von Cristobalit. Solche Entglasungsvorgänge können die Verdichtung im Sinterprozess behindern.

Hinsichtlich der Solarkokille zum Einsatz in einem Kristallzüchtungsprozess wird die oben angegebene technische Aufgabe ausgehend von einer mit einer Körnungsschicht versehenen Solarkokille der eingangs genannten Gattung erfindungsgemäß einerseits dadurch gelöst, dass die SiO₂-haltige Schicht als Körnungsschicht ausgebildet ist, die amorphe SiO₂-Teilchen enthält, die eine Grobfraktion mit Teilchengrößen im Bereich zwischen 1 µm bis 50 µm sowie eine Feinfraktion aus SiO₂-Nanoteilchen mit Teilchengrößen von weniger als 100 nm bilden,
- wobei der Gewichtsanteil der SiO₂-Nanoteilchen an der Körnungsschicht im Bereich zwischen 2 bis 15 Gew.-% liegt,
- und wobei die Feinfraktion innerhalb eines oberflächennahen Volumenbereichs der Körnungsschicht, nämlich einer Gießhaut, derart angereichert ist, dass SiO₂-Nanoteilchen einen Volumenanteil von mehr als 70 % ausmachen.

Hinsichtlich Reinheit und Porosität unterliegt der Kokillenbasiskörper keinen hohen Anforderungen. Im einfachsten Fall handelt es sich um eine handelsübliche Solarkokille aus porösem Quarzglas oder porösem Quarzgut mittlerer Reinheit.

Die Innenwandung der erfindungsgemäßen Solarkokille ist mit einer SiO₂-haltigen Körnungsschicht versehen, die bestimmungsgemäßen erst beim Kristallzüchtungsprozess beim Aufheizen des Siliziums thermisch zu der Diffusionssperrschicht verdichtet wird.

Wegen der Kristallisationsneigung des Kokillenbasiskörpers und den hohen Temperaturen, wie sie zur Verdichtung einer hochkieselsäurehaltigen Körnungsschicht grundsätzlich notwendig sind, stößt die Herstellung einer dichten Diffusionssperrschicht aus SiO₂-haltiger vor dem bestimmungsgemäßen Einsatz der Kokille auf Schwierigkeiten. Um die "red zone" im Siliziumblock signifikant zu reduzieren, werden geringe Eisengehalte von weniger als 2,5 Gew.-ppm, vorzugsweise weniger als 0,5 Gew.-ppm benötigt. Es hat sich gezeigt, dass dafür nicht nur eine dichte Diffusionssperrschicht erforderlich ist, sondern dass die Dichtigkeit der Diffusionssperrschicht beim Aufheizen der Silizium-Charge auch möglichst rasch gegeben sein muss, das heißt, vor Erreichen der Schmelztemperatur.

Sinterhilfsmittel und Bindemittel tragen zwar zu einem raschen Versintern der Körnungsschicht bei, fördern jedoch gleichzeitig die Kristallisationsneigung der Schicht und sind daher ungeeignet. Um dennoch eine schnelle und zuverlässige Verdichtung der Diffusionssperrschicht zu erreichen, sieht die Erfindung eine besonders sinteraktive Körnungsschicht vor. Ihre hohe Sinteraktivität wird durch eine mehrmodale Korngrößenverteilung erreicht, bei der amorphe SiO₂-Teilchen mit Teilchengrößen im Bereich zwischen 1 µm bis 50 µm (Grobfraktion) sowie SiO₂-Nanoteilchen (Feinfraktion) mit einem Gewichtsanteil zwischen 2 bis 15 Gew.-% vorgesehen sind (Gewichtsanteile bezogen auf den Feststoffgehalt der Körnungsschicht)

Die Sinterfähigkeit der Körnungsschicht hängt insbesondere von ihrer Zusammensetzung im oberflächennahen Bereich ab. Entscheidend ist dabei der Anteil an SiO₂-Nanoteilchen. Bei einem hohen Anteil ergibt sich eine höhere Sinteraktivität, die ein thermisches Verdichten bei vergleichsweise niedriger Temperatur oder kurzer Sinterdauer zu einem Glas mit höherer Dichte und geringer Porosität ermöglicht. Im Idealfall finden sich im oberflächennahen Bereich der Körnungsschicht nur relativ feine SiO₂-Teilchen.

Das oben erläuterte Verfahren der Erfindung führt zu einer derartigen Verteilung der SiO₂-Teilchen innerhalb der Körnungsschicht durch Entmischung. Diese erzeugt innerhalb der Körnungsschicht einen an die Kokillen-Innenwandung angrenzenden Innenbereich, in dem vorwiegend der Grobanteil der SiO₂-Teilchen zu finden ist, und einen an die freie Oberfläche der Schicht angrenzenden Außenbereich, in dem die Feinfraktion angereichert ist. Die Feinfraktion der SiO₂-Teilchen wird von Nanoteilchen gebildet.

Innerhalb der Körnungsschicht zeigt sich eine inhomogene Teilchengrößenverteilung aus, wobei der Übergang zwischen unterem und oberem Bereich nicht fließend-graduell, sondern ausgeprägter ist.

Um einen ausreichend hohen Anteil an SiO₂-Nanoteilchen im Außenbereich der Körnungsschicht zu erzielen, liegt der Anteil an SiO₂-Nanoteilchen innerhalb der Körnungsschicht insgesamt im Bereich von 2 bis 15 Gew.-%, wegen Schwindungsproblemen jedoch bevorzugt bei weniger als 10 Gew.-%.

Im Gegensatz zu üblichen Körnungsschichten, die sich durch eine weitgehend homogene Verteilung der Teilchengrößen über die Schichtdicke auszeichnen, ist die Körnungsschicht gemäß der Erfindung inhomogen, indem sie eine Variation in der Teilchengrößenverteilung über die Schichtdicke zeigt, mit einer Anreicherung von SiO₂-Nanoteilchen im oberflächennahen Außenbereich. Infolge dieser Anreicherung kann die Körnungsschicht leichter dichtgesintert werden als ohne diese Anreicherung. Das heißt, zum Dichtsintern sind eine geringere Sintertemperatur und/oder eine verkürzte Sinterdauer erforderlich als bei einer Körnungsschicht mit homogener Teilchengrößenverteilung. Bei sehr hohen Anteilen an SiO₂-Nanoteilchen wird eine Tendenz zur Rissbildung beim Trocknen oder Sintern beobachtet.

Innerhalb der Körnungsschicht zeigt sich ein besonders homogener, dichter und sinteraktiver oberflächennaher Volumenbereich mit einem relativ hohen Anteil an SiO₂-Nanoteilchen. Im oberflächennahen Volumenbereich ist deren Anteil somit höher ist als der mittlere Anteil der SiO₂-Nanoteilchen in der übrigen Körnungsschicht.

Der oberflächennahe Volumenbereich zeigt eine geringe Porosität. Die Dicke liegt bevorzugt im Bereich von 3 bis 15 µm, besonders bevorzugt im Bereich von 5 bis 10 µm. Im oberflächennahen Volumenbereich macht die Feinfraktion aus SiO₂-Nanoteilchen mit Teilchengrößen von weniger als 100 nm einen Volumenanteil von mehr als 70 %, bevorzugt einen Volumenanteil von mehr als 80 % aus.

Es hat sich gezeigt, dass eine derartige Körnungsschicht reproduzierbar und bei mäßigen Sinterbedingungen (das heißt: vergleichsweise niedrige Sintertemperatur und/oder kurze Sinterdauer) zu einer dichten, transluzenten Quarzglasschicht mit verhältnismäßig geringer Oberflächenrauigkeit gesintert werden kann. Diese mäßigen Sinterbedingungen sind beim bestimmungsgemäßen Einsatz der Kokille beim Erhitzen der Silizium-Charge regelmäßig erfüllt, bevor die Maximaltemperatur im Kristallzüchtungsprozess, beispielsweise die Schmelztemperatur des Siliziums (etwa 1.410 °C), erreicht ist. Dabei verbleibt im Bereich des ehemaligen oberflächennahen Volumenbereichs eine dünne Schicht mit geringer und geschlossener Porosität von vorzugsweise maximal 10 %. Dieser Prozentwert markiert in etwa den Übergang zwischen offener Porosität (>10%) und geschlossener Porosität (<10%). Ein Material mit einer Porosität von weniger als 10 % wird daher hier als "dicht" bezeichnet. Es hat sich gezeigt, dass eine derart dünne, aber dichte Oberflächenschicht bereits eine wirksame Diffusionsbarriere für Eisen darstellt.

Das endgültige Verdichten der Körnungsschicht erst beim bestimmungsgemäßen Einsatz der Kokille vereinfacht den Fertigungsprozess und erspart einen ansonsten erforderlichen Heißbearbeitungsprozess. Dies schließt nicht aus, dass die Körnungsschicht auch vorher bereits hohen Temperaturen unterworfen worden ist, beispielsweise zum Sintern der Kokillenwandung bei einer Temperatur unterhalb der Cristobalit-Bildungstemperatur oder zum Einbrennen einer Oberflächenschicht aus Si₃N₄, was typischerweise unterhalb 1.200 °C erfolgt. Allerdings kann ein mehrfaches Aufheizen der Körnungsschicht auf hohe Temperaturen zu unerwünschten Wechselwirkungen mit angrenzenden Schichtbereichen führen, so dass dies nicht bevorzugt ist.

Es hat sich gezeigt, dass bei Einsatz einer erfindungsgemäßen Solarkokille zur Herstellung eines Siliziumblocks in einem Bridgeman- oder VGF-Prozess "red zone" und dunkler Zell-Rand deutlich reduziert beziehungsweise vermieden werden.

Es hat sich bewährt, wenn die Feinfraktion innerhalb eines oberflächennahen Volumenbereichs der Körnungsschicht derart angereichert ist, dass SiO₂-Nanoteilchen einen Volumenanteil von mehr als 70 %, bevorzugt einen Volumenanteil von mehr als 80 % ausmachen.

Die SiO₂-Nanoteilchen liegen im oberflächennahen Volumenbereich der Körnungsschicht in der Regel nicht vereinzelt, sondern in Form von Aggregaten oder Agglomeraten vor, die die wenigen SiO₂-Teilchen der Grobfraktion teilweise oder vollständig einbetten. Da die Porosität im oberflächennahen Volumenbereich gering ist, entspricht der Volumenanteil ungefähr dem Gewichtsanteil der SiO₂-Nanoteilchen. Ein Volumenanteil von mehr als 70 % entspricht demnach einer Anreicherung um mehr als dem10-fachen gegenüber dem typischen Anteil um 7 % an SiO₂-Nanoteilchen im oberflächennahen Volumenbereich der Körnungsschicht.

Vorteilhafte Ausgestaltungen der erfindungsgemäßen Solarkokille ergeben sich aus den Unteransprüchen. Soweit in den Unteransprüchen angegebene Ausgestaltungen der Solarkokille den in Unteransprüchen zum erfindungsgemäßen Herstellungsverfahren genannten Verfahrensweisen nachgebildet sind, wird zur ergänzenden Erläuterung auf die obigen Ausführungen zu den entsprechenden Verfahrensansprüchen verwiesen.

Offene Porosität eines Materials zeigt sich darin, dass es saugfähig ist, was anhand eines Farbeindringtests nachweisbar ist. Das Fehlen offener Poren wird bei einer Porosität von weniger als 10 % angenommen. Ein Material mit einer Porosität von weniger als 10 % wird daher hier als "dicht" bezeichnet. Die dichte Diffusionssperrschicht - ohne offene Porosität - vermindert die vergleichsweise schnelle Oberflächendiffusion - insbesondere von Eisen - und erlaubt nur noch die vergleichsweise langsamere Volumendiffusion.

Es hat sich gezeigt, dass bei Einsatz der erfindungsgemäßen Solarkokille zur Herstellung eines Siliziumblocks in einem Bridgeman- oder VGF-Prozess sowohl die "red zone" im Siliziumblock als auch der "dunkle Rand" signifikant reduziert beziehungsweise vermieden werden können.

Hinsichtlich des Verfahrens zur Herstellung eines Siliziumblocks in einem Kristallzüchtungsprozess durch Bereitstellen einer Solarkokille mit einem eine Innenwandung aufweisenden Kokillenbasiskörper aus Quarzglas oder aus Quarzgut, von der mindestens ein Teil von einer SiO₂-haltigen Körnungsschicht bedeckt ist, wird die oben angegebene technische Aufgabe erfindungsgemäß dadurch gelöst, dass eine Solarkokille eingesetzt wird, bei der die Körnungsschicht amorphe SiO₂-Teilchen enthält, die eine Grobfraktion mit Teilchengrößen im Bereich zwischen 1 µm bis 50 µm sowie eine Feinfraktion aus SiO₂-Nanoteilchen mit Teilchengrößen von weniger als 100 nm bilden, wobei der Gewichtsanteil der SiO₂-Nanoteilchen an der Körnungsschicht im Bereich zwischen 2 bis 15 Gew.-% liegt, wobei die Feinfraktion aus SiO₂-Nanoteilchen mit Teilchengrößen von weniger als 100 nm innerhalb eines oberflächennahen Volumenbereichs der Körnungsschicht, nämlich einer Gießhaut, derart angereichert ist, dass die SiO₂-Nanoteilchen einen Volumenanteil von mehr als 70 % ausmachen, und dass die SiO₂-haltige Körnungsschicht beim Aufheizen des Siliziums thermisch verdichtet wird

Im einfachsten Fall ist der Kokillenbasiskörper eine handelsübliche Solarkokille aus porösem Quarzglas oder porösem Quarzgut mittlerer Reinheit. Dessen Innenwandung wird vorab - das heißt vor dem Einfüllen einer Silizium-Charge - vollständig oder teilweise mit einer SiO₂-haltigen Körnungsschicht versehen. Für die Herstellung der mit der Körnungsschicht versehenen Solarkokille ist das oben erläuterte Herstellungsverfahren geeignet. Optional kann die Körnungsschicht noch mit einer Trennmittelschicht bedeckt werden, beispielsweise mit Si₃N₄ als Trennmittel.

Nach dem Beladen mit der Silizium-Charge wird die Solarkokille in üblicher Weise aufgeheizt. Je nach Kristallzüchtungsmethode wird dabei das eingefüllte Silizium vollständig aufgeschmolzen, oder es wird nur eine Siliziumschmelze oberhalb eines am Kokillenboden angeordneten festen Kristallkeims erzeugt. Im zuletzt genannten Fall wird der Bodenbereich der Solarkokille auf einer Temperatur unterhalb der Schmelztemperatur von Silizium gehalten, beispielsweise auf einer Temperatur von 1375 °C. Die Heizenergie wird in der Regel über außerhalb der Solarkokille angeordnete Widerstandheizer eingekoppelt, die mehrere, getrennt einstellbare Heizzonen bilden. Nach einer Homogenisierung der Schmelze beginnt die Abkühlungsphase, um eine gerichtete Kristallisation einzuleiten.

Während der Aufheizphase kommt es zu einem Dichtsintern der Körnungsschicht. Die Verdichtung ist im Idealfall vor Erreichen der Maximaltemperatur abgeschlossen. Es hat sich bewährt, wenn die Körnungsschicht eine Dichte von mehr als 90%, bevorzugt mindestens 93%, ihrer theoretischen Dichte erreicht hat bevor sich die Siliziumschmelze bildet.

Die dicht gesinterte Körnungsschicht bildet eine effektive Diffusionssperrschicht; sie vermindert die Eindiffusion von Verunreinigungen aus der Kokillenwandung in die Siliziumschmelze und den sich bildenden Siliziumblock.

Beim Schmelz- und Kristallisationsprozess kristallisiert das verunreinigte Quarzgut des Kokillenbasiskörpers zu Cristobalit, wohingegen die Körnungsschicht glasig bleibt. Beim Abkühlen führt die Phasenumwandlung des Cristobalits und der damit verbundene Volumensprung von 2,8% zum Reißen des Basiskörpers.

Der nach dem oben erläuterten Verfahren unter Einsatz einer Diffusionssperrschicht anhand eines Bridgeman- oder VGF-Prozesses erzeugte Siliziumblock zeichnet sich durch geringe Materialverluste aus. Im Vergleich zu einem Standardprozess ohne Diffusionssperrschicht sind sowohl die "red zone" als auch der "dunkle Rand" (mit den eingangs dafür spezifizierten Messmethoden LTLD und PL ermittelt) signifikant reduziert.

### Ausführungsbeispiel

Nachfolgend wird die Erfindung anhand von Ausführungsbeispielen und einer Zeichnung näher erläutert. Dabei zeigt im Einzelnen
- **Figur 1**: eine REM-Aufnahme einer Sinterprobe einer Quarzgutplatte mit aufgeschlickerter SiO₂-Sperrschicht nach einer Sinterdauer von 3h bei 1300°C,
- **Figur 2**: eine REM-Aufnahme einer Sinterprobe einer Quarzgutplatte mit aufgeschlickerter SiO₂-Sperrschicht nach einer Sinterdauer von 3h bei 1500°C
- **Figur 3**: Foto einer Grünschicht bei einer Referenzprobe,
- **Figur 4**: in schematischer Darstellung eine mit einer Körnungsschicht versehene Quarzgut-Kokille gemäß der Erfindung in einer Seitenansicht,
- **Figur 5**: eine MDP-Aufnahme (microwave detected photoconductivity) der Ladungsträgerlebensdauer in einem typischen Siliziumblock, vertikal geschnitten,
- **Figur 6**: einen Vergleich der mittels MDP-Messungen ermittelten Dicken von seitlichen Eindiffusionsschichten bei Siliziumblöcken, hergestellt mittels Solarkokillen mit und ohne Diffusionssperrschicht,
- **Figur 7**: Ergebnissen von Photolumineszenz-Messungen an Siliziumzellen aus dem Eckbereich, hergestellt mit und ohne Diffusionssperrschicht,
- **Figur 8**: ein Diagramm mit Konzentrationsverläufen der GesamtEisenkonzentration, gemessen an mehreren polierten Gefügeproben quer zur Schicht, und
- **Figur 9**: ein Diagramm mit Ergebnissen von GDMS-Messungen an Siliziumblöcken.

### Herstellen eines SiO₂-Schlickers - erste Alternative

In eine Dispersionsflüssigkeit wird in einer mit Quarzglas ausgekleideten Trommelmühle eine amorphe Quarzglaskörnung eingemischt. Die Quarzglaskörnung besteht aus Quarzglas, das aus natürlich vorkommendem Rohstoff erzeugt worden ist und hat Korngrößen im Bereich zwischen 250 µm und 650 µm. Diese Mischung wird mittels Mahlkugeln aus Quarzglas auf einem Rollenbock bei 23 U/min während einer Dauer von 3 Tagen soweit vermahlen, dass sich ein homogener Schlicker bildet. Im Verlauf des Vermahlens kommt es infolge des in Lösung gehenden SiO₂ zu einer Absenkung des pH-Werts auf etwa 4.

Die nach dem Vermahlen der Quarzglaskörnung erhaltenen SiO₂-Körnungs-teilchen sind splittriger Natur und zeigen eine Teilchengrößenverteilung, die durch einen D₅₀- Wert von etwa 8 µm und durch einen D₉₀-Wert von etwa 40 µm gekennzeichnet ist. Dem homogenen Schlicker werden SiO₂-Nanoteilchen mit Durchmessern um 40 nm ("pyrogene Kieselsäure") mit einem Gewichtsanteil von 10 Gew.-% (bezogen auf den Feststoffgehalt der Dispersion) hinzugefügt. Nach weiterer Homogenisierung wird ein bindemittelfreier SiO₂-Schlicker erhalten. Der Feststoffgehalt der Dispersion liegt bei 75 Gew.-%; der SiO₂-Gehalt der amorphen SiO₂-Teilchen beträgt mindestens 99,99 Gew.-% und der Gesamt-Gehalt an metallischen Verunreinigungen der Übergangselemente weniger als 2,5 Gew.-ppm. Der Gehalt an Eisen liegt unterhalb von 0,5 Gew.-ppm.

### Herstellen eines SiO₂-Schlickers - zweite Alternative

Anstelle der Quarzglaskörnung aus natürlich vorkommendem Rohstoff wird eine SiO₂-Körnung aus synthetisch erzeugtem Quarzglas eingesetzt, das einen Hydroxylgruppengehalt von etwa 800 Gew.-ppm aufweist. Diese SiO₂-Körnung ist in hochreiner Form und in unterschiedlichen Korngrößen im Handel erhältlich. Der SiO₂-Gehalt der amorphen SiO₂-Teilchen beträgt mindestens 99,99 Gew.-% und der Gesamt-Gehalt an metallischen Verunreinigungen der Übergangselemente weniger als 1 Gew.-ppm. Der Gehalt an Eisen liegt unterhalb von 0,1 Gew.-ppm.

Die Dispersion aus entionisiertem Wasser amorpher SiO₂-Körnung mit einer mittleren Teilchengröße um 15 µm (D₅₀-Wert) wird ohne Mahlkugeln homogenisiert. Dem homogenen Schlicker werden SiO₂-Nanoteilchen mit Durchmessern um 40 nm ("pyrogene Kieselsäure") hinzugefügt. Nach weiterer Homogenisierung wird ein bindemittelfreier SiO₂-Schlicker, in dem die SiO₂-Nanoteilchen einen Gewichtsanteil von 8 Gew.-% (bezogen auf den Feststoffgehalt der Dispersion) haben, wobei der Gesamt-Feststoffgehalt der Dispersion bei 75 Gew.-% liegt.

### Vorversuch - Probe 1

Das Kokillenmaterial aus Quarzgut hat eine offene Porosität und bildet ein saugfähiges Substrat für den Schlickerguss. Auf diesem Material (Scherben) wird aus dem bindemittelfreien Schlicker eine Schlickerschicht durch Aufrakeln (auch als "Aufgießen" zu bezeichnen) erzeugt. Hierbei wird auf der horizontal gelagerten Platte eine ca. 1 mm dicke SiO₂-Schlickerschicht aufgerakelt, und unmittelbar danach wird mittels der Rakeleinrichtung ein mechanischer Druck auf die Schlickerschicht ausgeübt.

Auf der so aufgebrachten und verdichteten Schlickerschicht bildet sich ein dünner Flüssigkeitsfilm und beim nachfolgenden Antrocknen an Luft eine homogene und geschlossene Oberflächenschicht aus.

Es entsteht ein Scherbenaufbau, der makroskopisch zur Bildung einer dichten, gleichmäßig dicken Schicht führt, die sowohl als trockene Grünschicht als auch als Sinterschicht im gesinterten Zustand einen innigen Haftverbund mit dem Kokillensubstrat eingeht. Eine mikroskopische Betrachtung zeigt einen hohen entmischten Feinanteil im oberen Bereich der Schicht (Gießhaut). Innerhalb der Gießhaut ist der Anteil feiner SiO₂-Teilchen und insbesondere von SiO₂-Nanoteilchen nennenswert höher als im Rest der Schlickerschicht.

Die Art und Weise des Auftragens der kompletten Schichtdicke in einem Arbeitsgang stellt zum einen ein hinreichend großes Reservoir an SiO₂-Nanoteilchen auf einmal zur Verfügung, das zur Entmischung an der Oberfläche geeignet ist, und zum anderen wird ein zu schnelles Trocknen der Schicht an Luft verhindert, das andernfalls der Entmischung und Gießhaut-Ausbildung entgegenwirken würde. Daher ergibt sich eine langsamere Trocknung von etwa 3 bis 5 min und eine Verfestigung der Schlickerschicht zur tragenden Schicht, die die Ausbildung einer im Wesentlichen glatten Gießhaut ermöglicht.

Beim Aufgießen enthält die Schlickerschicht ihre Endform unter Einwirkung eines Werkzeugs, wie etwa einer Rakel, einem Pinsel, einer Spachtel oder einer Auslaufdüse, aus der beim Auftragen ein kontinuierlicher Schlickerstrahl ausläuft. Durch streichende Einwirkung des Bearbeitungswerkzeugs wird die Schichtoberfläche etwas flüssiger, was das Anreichern von SiO₂-Nanoteilchen auch bei verhältnismäßig geringem Flüssigkeitsgehalt erleichtert. Dieses Ergebnis - das heißt, keine nennenswerte Verringerung des Flüssigkeitsgehalts des Schlickers - ist auch bei anderen Auftragstechniken (wie Aufspritzen) zu erwarten, bei denen die Schlickerschicht in ihrer gesamten Dicke auf einmal und ohne Zerteilung in feine Tropfen von weniger als 1 mm erzeugt wird.

Die so erzeugte Schlickerschicht wird innerhalb von 3 Minuten zu einer tragenden Schicht und anschließend weiter langsam getrocknet, indem sie an Luft 1 Stunde ruht. Dabei erhält die Gießhaut ein wachsartiges Erscheinungsbild. Die vollständige Trocknung erfolgt unter Einsatz eines IR-Strahlers an Luft während 4 bis 8 Stunden.

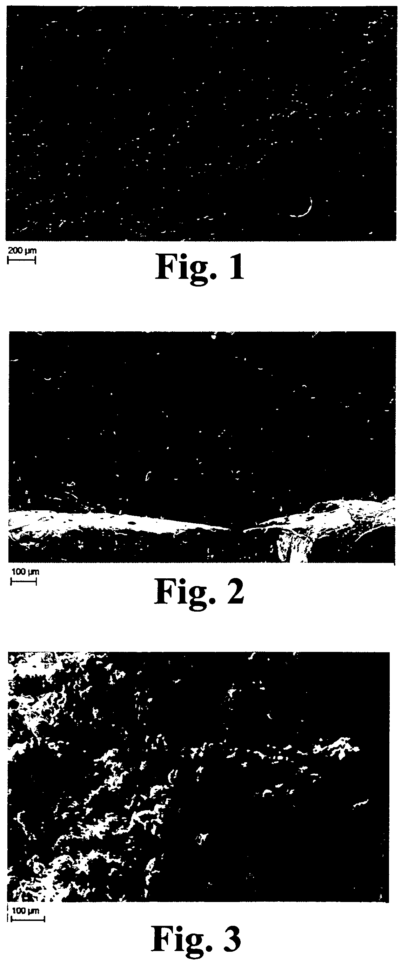

Die getrocknete Schlickerschicht hat eine mittlere Dicke von etwa 0,8 mm Sie wird auch als "Grünschicht" bezeichnet. Die im Oberflächenbereich der Grünschicht angereicherten SiO₂-Nanoteilchen zeigen eine hohe Sinteraktivität und verbessern die Verdichtung der Schicht. **Figur 1** zeigt die so erzeugte Schicht nach einem dreistündigen Sintern in einem Sinterofen bei einer Temperatur um 1300 °C. Dabei ist noch keine vollständige Verdichtung erreicht. Deutlich erkennbar ist die raue, zerklüftete Bruchoberfläche mit vielen feinverteilten Poren.

Im Vergleich dazu zeigt **Figur 2** das Erscheinungsbild einer gleichartigen Sinterschicht nach dreistündigem Sintern bei höherer Temperatur von 1.500 °C. Es wird eine rissfreie und im Wesentlichen glatte stark verdichtete und verglaste Bruchoberfläche aus opakem Quarzglas mit einer Dichte von etwa 2,1 g/cm³ erhalten. Die Oberflächenschicht zeigt eine geschlossene Porosität von weniger als 5% und eine Dicke von etwa 750 µm. (Anmerkung: Der Übergang von offener zu geschlossener Porosität liegt laut Literaturangaben im Bereich von 5-10%).

Weder die Schicht von Figur 1 noch die Schicht von Figur 2 zeigen Hinweise auf etwaige Kristallisationsprodukte, weder im Inneren noch auf der Oberfläche.

Die hohe Sinteraktivität der erfindungsgemäß erzeugten Körnungsschicht ergibt sich aus den Angaben von **Tabelle 1.** Hier sind Sinterdauer und Sintertemperatur und das jeweilige Sinterergebnis in einer Kreuztabelle zusammengefasst.

**Tabelle 1**

| | **0,5h** | **1h** | **3h** | **5h** |
|---|---|---|---|---|
| **1.300 °C** | opak/porös | opak/porös | opak/porös | opak/porös |
| **1.350 °C** | opak/porös | opak/porös | opak/porös | opak/porös |
| **1.375 °C** | opak/porös | opak/porös | transluzent / dicht | transluzent / dicht |
| **1.400 °C** | transluzent / dicht | transluzent / dicht | transluzent / dicht | |
| **1.450 °C** | | | transluzent / dicht | |

"Opak/porös" bedeutet dabei, dass die erforderliche Dichtigkeit der Schicht nicht gegeben und diese nicht als Diffusionssperrschicht im Sinne der Erfindung geeignet ist. Die Porosität beträgt mehr als 10% und die Dichte weniger als 90% der theoretischen Dichte von Quarzglas (etwa 2,2 g/cm³).

"Transluzent/dicht" bedeutet, dass die verdichtete Sinterschicht eine Dichte von mindestens 90%, vorzugsweise mindestens 95 % der theoretischen Dichte hat, so dass sie als Diffusionssperrschicht im Sinne der Erfindung geeignet ist.

Bei Kristallzüchtungsprozessen wird die Kokillenwand auf Temperaturen im Bereich zwischen 1.375 °C und etwa 1.450 °C aufgeheizt. Unter der Annahme, dass beim Aufheizen einer Silizium-Charge in einer Kokille typischerweise mindestens eine Stunde vergeht, bis die Maximaltemperatur erreicht ist, hat die Körnungsschicht in der Regel den Stand "transluzent/dicht" und somit eine Dichte von mindestens 95% ihrer theoretischen Dichte erreicht. Dies gilt nur eingeschränkt für die Maximaltemperatur von 1.375 °C, die der Kokillenboden im sogenannten "Quasi-Mono-Prozess" hat. In diesem Fall wird die gewünschte Dichtheit der Körnungsschicht erst nach 3 Stunden erreicht.

### Referenzbeispiel - Probe 2

Der eingangs beschriebene, bindemittelfreie SiO₂-Schlicker hat eine geringe Viskosität und ist an und für sich unmittelbar als Sprühschlicker einsetzbar. In einem Versuch wurde dieser Schlicker zur Herstellung einer Sprühbeschichtung auf dem saugfähigem, opakem Quarzgutscherben mit offener Porosität eingesetzt.

Zur Beschichtung wurde die Quarzgutplatte in horizontaler Orientierung in eine Sprühkammer eingebracht und die Oberseite sukzessive durch Aufsprühen des Schlickers mit einer tragenden ca. 0,7 mm dicken SiO₂-Schlickerschicht versehen. Hierfür wurde eine Sprühpistole eingesetzt, der kontinuierlich der Sprühschlicker zugeführt wird.

Auf der so sukzessive aufgebrachten Schlickerschicht bildet sich beim nachfolgenden Antrocknen an Luft innerhalb einer Minute eine raue und zerklüftete Oberflächenschicht. Dieses Ergebnis wird jedenfalls teilweise darauf zurückgeführt, dass das Trocknen der Schlickerschicht wegen des porösen Untergrundes so rasch erfolgte, dass eine Entmischung des Feinanteils im oberen Bereich der Schlickerschicht nicht möglich war, so dass sich keine dichte und geschlossene Gießhaut ausbilden konnte.

Das weitere Trocknen erfolgte dann langsam, indem die Schlickerschicht an Luft acht Stunden lang ruht. Die vollständige Trocknung erfolgt unter Einsatz eines IR-Strahlers an Luft während 4 Stunden.

Es wird eine raue und rissige inhomogene Oberflächenschicht aus opakem, porösem Quarzglas erhalten, die das in **Figur 3** gezeigte Erscheinungsbild hat.

Die getrocknete Grünschicht konnte anschließend in einem Sinterofen bei einer Temperatur um 1.410 °C zu einer verdichteten Sinterschicht aus transluzentem Quarzglas mit einer Dichte von etwa 2,0 g/cm³ gesintert werden. Diese Dichte ist für eine Diffusionssperrschicht noch akzeptabel.

### Beschichtung einer Kokille

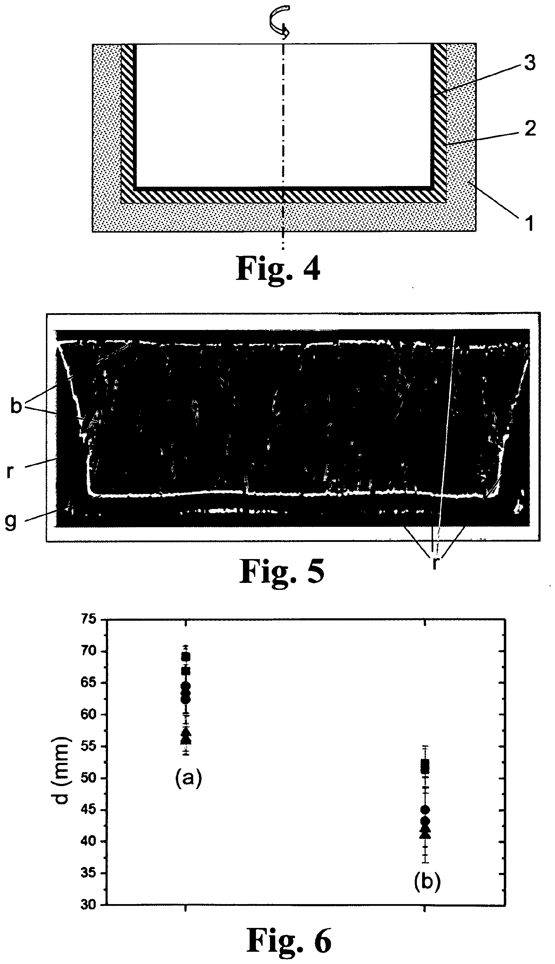

Das Beschichten einer handelsüblichen Quarzgutkokille 1 - hergestellt aus Quarzglas aus natürlich vorkommendem Rohstoff - erfolgte in einem mehrstufigen Aufbau, den **Figur 4** schematisch zeigt.

Das Aufbringen der zur Diffusionsbarriere auszubildenden SiO₂-Körnungschicht 2 erfolgte allseitig (Boden und Seitenwände) auf eine auf Raumtemperatur temperierte, vorbefeuchtete Innenwand der Kokille 1 aus porösem Quarzgut. Damit können Schichten unterschiedlicher Dicke und geometrischer Ausbildung erzeugt werden. Im Ausführungsbeispiel erfolgte die Herstellung der Körnungsschicht unter Einsatz des oben - erste Alternative - beschriebenen SiO₂-Schlickers und anhand des in Vorversuch - Probe 1 beschriebenen Verfahrens zum Aufbringen (durch Aufrakeln) und Trocknen der Schlickerschicht. Die so erzeugte Grünschicht (=Körnungsschicht 2) hat nach dem Trocknen eine weitgehend gleichmäßige Dicke von im Mittel etwa 0,8 mm. Die Dicke der daraus nach dem Sintern (beim Kristallzüchtungsprozess) erzielten Diffusionssperrschicht ist etwa 10 % geringer und liegt demnach bei etwa 0,7 mm. Nach dem Auftragen dieser Körnungsschicht 2 wurde diese mit einer Suspension aus Siliziumnitrid, Siliziumdioxid und DI-Wasser beschichtet (Schicht 3).

Die beschichtete Quarzgutkokille wurde in einem Kristallzüchtungsprozess eingesetzt, der im Folgenden näher erläutert wird. Dabei wurde die Körnungsschicht gesintert und somit thermisch zu einer dichten Diffusionssperrschicht mit einer mittleren Dicke um 0,6 mm verdichtet.

### Herstellung eines Siliziumblocks

Die Kristallzüchtung zur Herstellung einer Siliziumblocks erfolgte unter Einsatz der beschichteten Quarzgut-Kokille und ansonsten in einem Standardprozess, wie er beispielsweise in der DE 10 2005 013 410 B4 beschrieben ist.

Beim Erhitzen im Kristallzüchtungsprozess bildet sich aus der Körnungsschicht eine verdichtete SiO₂-Sperrschicht mit einer Dicke von im Mittel etwa 0,6 mm und einer Porosität von weniger als 10 %. Diese Sperrschicht zeigt keine offene Porosität und wirkt wirksam als Diffusionssperrschicht gegenüber der schnellen Oberflächendiffusion von Verunreinigungen, insbesondere von Eisen.

### Messergebnisse

**Figur 5** zeigt einen typischen Siliziumblock-Querschnitt, vermessen mittels "MDP" ("microwave detected photoconductivity"). Mittels dieser Messmethode wird die Minoritätsladungsträgerlebensdauer (LTLD) in einem Halbleitermaterial ermittelt. Die Minoritätsladungsträgerlebensdauer wird üblicherweise in Falschfarbendarstellung veranschaulicht - im Bild 5 ist die Darstellung in Graustufen gehalten und die Grauwerte entsprechenden den eigentlich farblichen Bereiche ergänzend mit den Angaben "g" (grün), "b" (blau) und "r" (rot) versehen. Eine hohe Ladungsträgerlebensdauer ist den grünen und blauen Messpunkten zugeordnet. Die Falschfarben-Darstellung ist so skaliert, dass den Zonen mit einer niedrigen Ladungsträgerlebensdauer (LTLD < 6 µs) die rote Farbe zugeordnet wird. Die dabei rot eingefärbten Zonen repräsentieren somit die Eindiffusionszonen mit geringer Ladungsträgerlebensdauer. Sie stellen den minderwertigen Materialbereich dar, der hier als "red zone" bezeichnet wird. Die zu entfernende Schwartenstärke richtet sich an der Dicke der red zone aus.

Deutlich ist die "red zone" am Boden und in den seitlichen Blockbereichen zu erkennen; sie wird hier überwiegend durch Festkörper-Diffusion von Verunreinigungen aus der Solarkokille verursacht.

Das Diagramm von **Figur 6** zeigt einen Vergleich der mittels MDP-Messungen sichtbar gemachten Eindiffusionszonen für einen Siliziumblock aus einer Kokille ohne Diffusionssperrschicht (Messreihe (a)) und für einen Siliziumblock aus einer Kokille mit Diffusionssperrschicht (Messreihe (b)). Auf der Ordinate ist dabei jeweils die an mehreren Höhenpositionen des Siliziumblocks gemessene Breite d der seitlichen Eindiffussionszone (in mm) aufgetragen. Die Messpunkte etwa gleieher Höhenposition beider Messreihen sind jeweils als Dreiecke, Kreise und Quadrate dargestellt.

Daraus ist ersichtlich, dass beim Siliziumblock aus der Kokille mit Diffusionssperrschicht (Messreihe b) sowohl die seitliche Eindiffusionszone insgesamt als auch der Bereich niedriger Ladungsträgerlebensdauer (red zone) vergleichsweise dünn ist.

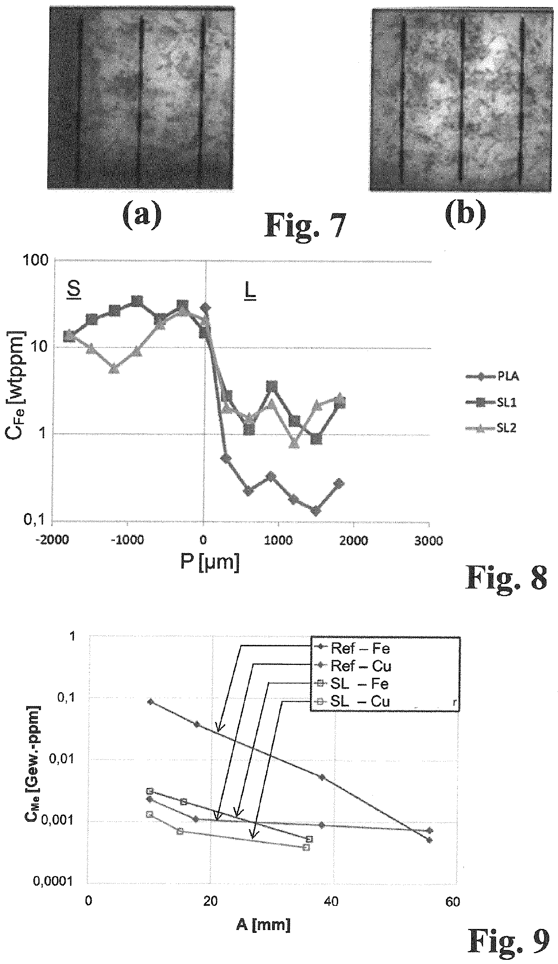

**Figur 7** zeigt Abbildungen von prozessierten Eckwafern, bei denen durch Photolumineszenz der Zellwirkungsgrad sichtbar gemacht ist. Die beiden Eckwafer sind aus Siliziumblöcken aus gleicher Blockhöhe entnommen. Der in Abbildung (a) gezeigte Wafer stammt aus einem Siliziumblock, der in einer Kokille ohne Diffusionsbarriere hergestellt worden ist. Der Eckwafer zeigt zwei dunkle Randbereiche, die auf Grund von schädlicher Eindiffusion eine geringere Ladungsträgerkonzentration aufweisen. Der Eckwafer gemäß Abbildung (b) entstammt einem Block mit Diffusionsbarriere. Bei diesem Wafer ist der dunkle Randbereich deutlich kleiner.

Bei den Eisen-Konzentrationsprofilen von **Figur 8** ist die Konzentration von Eisen C_{Fe} in Gew.-ppm gegen die Messposition P (in µm) aufgetragen. Die Profile wurden an polierten Querschliffen der beschichteten Kokillen nach Abschluss eines Kristallzüchtungsprozesse gemessen.

Die Gesamt-Konzentration der Eisen-Verunreinigung wurde durch induktionsgekoppelte Plasmamassenspektroskopie (ICP-MS) ermittelt. Die mit "SL1" und "SL2" bezeichneten Proben wurden mittels Kokillen mit schlickerbasierter Diffusionssperrschicht gemäß der Erfindung gefertigt. Bei der mit "PLA" bezeichneten Vergleichsprobe wurde die Diffusionssperrschicht unter Einsatz von Einlegeplatten aus Quarzglas hergestellt, wie in der oben genannten DE 10 2011 082 628 A1 beschreiben. Der Wert Null auf der x-Achse kennzeichnet die Grenzfläche zwischen der Kokillenwandung (Substrat S) und den jeweiligen Diffusionssperrschichten (L).

Es ist zu erkennen, dass die Diffusionssperrschichten L nach dem Si-Schmelzprozess deutlich geringere Fe-Konzentrationen aufweisen als das Kokillenmaterial (Substrat). Ein Diffusionsprofil ist erkennbar. Bemerkenswert ist das höhere Konzentrationsniveau der schlickerbasierten Schichten (SL1 und SL2), die ursprünglich beim Auftragen deutlich reiner waren (Fe-Niveau ca. 0,2 Gew.-ppm, also ähnlich dem Konzentrationsniveau der Plattenprobe). Dies ist ein Hinweis darauf, dass bereits beim Aufheizen bzw. Verdichten der Probe eine gewisse Anreicherung mit Fe eintritt, das die ganze Schicht durchdringt. Damit ergibt sich eine wesentliche technische Forderung nach schnellstmöglicher Verdichtung der Schicht.

Bemerkenswert ist, dass der SiO₂-Ausgangsschlicker eine Fe-Ausgangskonzentration hat, die in etwa dem asymptotischen Niveau des SiO₂-Plattenmaterials ("PLA") entspricht. Die Tatsache, dass das Fe-Konzentrationsniveau nach dem Schmelzprozess auf knapp über 1 ppm gestiegen ist, spricht für eine Anreicherung der gesamten Schicht während des Verdichtungsvorgangs. Da davon auszugehen ist, dass die am Ende stark verdichtete Schicht sich ähnlich verhalten dürfte wie das von Anfang an dichte Plattenmaterial spricht für die Annahme, dass die anfängliche Porosität diese Anreicherung begünstigt - und für die Folgerung, dass das Material bei möglichst niedrigen Temperaturen (unterhalb 1410°C) verdichten sollte.

**Figur 9** zeigt Ergebnisse einer GDMS-Messung (Glimmemtladungs-Massenspektrometrie) für einen ohne Diffusionssperrschicht erzeugten Silizium-Referenzblock (bezeichnet als "Ref") und einen gemäß der Erfindung mit Diffusionssperrschicht hergestellten Siliziumblock (Bezeichnet als ""SL") im Vergleich. Auf der Ordinate des Diagramms ist hier der jeweilige Metallgehalt (Eisen, Kupfer) C_{Me} in Gew.-ppm in logarithmischer Skala gegen den Abstand A (in mm) von der Kokillenwand aufgetragen. Daraus ist ersichtlich, dass die Metall-Konzentration mit zunehmendem Abstand geringer wird und dass eine Reduktion des Eisen- und Kupfergehalts im fertigen Siliziumblock durch Einsatz der SiO₂-Diffusionsbarriere erreicht werden konnte. Auffällig ist, dass bei der Probe mit Diffusionssperrschicht für Eisen(SL-Fe) nicht nur die Randkonzentration, sondern auch das gesamte Profil deutlich niedriger verläuft als bei der Referenzprobe (Ref-Fe) ohne Diffusionssperrschicht.

## Patentansprüche

1. Verfahren zur Herstellung einer Solarkokille mit Rechteckform zum Einsatz in einem Kristallzüchtungsprozess für Silizium, indem ein eine Innenwandung aufweisender Kokillenbasiskörper aus Quarzglas oder aus Quarzgut sowie eine amorphe SiO₂-Teilchen enthaltende Dispersion bereitgestellt werden, unter Einsatz der Dispersion eine SiO₂-haltige Schlickerschicht mit einer Schichtdicke von mindestens 0,1 mm auf mindestens einem Teil der Innenwandung aufgebracht wird, und die Schlickerschicht getrocknet und unter Ausbildung einer Diffusionssperrschicht thermisch verdichtet wird, **dadurch gekennzeichnet,**
(a) **dass** die Dispersion eine Dispersionsflüssigkeit und amorphe SiO₂-Teilchen enthält, die eine Grobfraktion mit Teilchengrößen im Bereich zwischen 1 µm bis 50 µm sowie eine Feinfraktion mit SiO₂-Nanoteilchen mit Teilchengrößen von weniger als 100 nm bilden,
• wobei der Gewichtsanteil der SiO₂-Nanoteilchen bezogen auf den Feststoffgehalt der Dispersion im Bereich zwischen 2 und 15 Gew.-% beträgt, und
• wobei die Feinfraktion aus SiO₂-Nanoteilchen mit Teilchengrößen von weniger als 100 nm einen Volumenanteil einer Gießhaut von mehr als 70 % ausmachen,
(b) und **dass** die SiO₂-haltige Körnungsschicht erst durch Aufheizen des Siliziums beim Kristallzüchtungsprozess thermisch zu der Diffusionssperrschicht verdichtet wird.

2. Verfahren nach Anspruch 1, **dadurch gekennzeichnet, dass** der Feststoffgehalt der Dispersion weniger als 80 Gew.-%, vorzugsweise zwischen 70 bis 80 Gew.-% beträgt und besonders bevorzugt zwischen 74 und 78 Gew.-% liegt.

3. Verfahren nach einem der vorhergehenden Ansprüche, **dadurch gekennzeichnet, dass** die Dispersion frei von Bindemittel ist und dass der SiO₂-Gehalt der amorphen SiO₂-Teilchen mindestens 99,99 Gew.-% beträgt, wobei der Gesamt-Gehalt an metallischen Verunreinigungen der Übergangselemente weniger als 5 Gew.-ppm, besonders bevorzugt weniger als 2,5 Gew.-ppm und der Gehalt an Eisen weniger als 2 Gew.-ppm, bevorzugt weniger als 1 Gew.-ppm und besonders bevorzugt weniger als 0,5 Gew.-ppm betragen.

4. Verfahren nach einem der vorhergehenden Ansprüche, **dadurch gekennzeichnet, dass** die Schlickerschicht durch Aufgießen oder Aufspritzen der Dispersion auf die Innenwandung aufgebracht wird.

5. Verfahren nach einem der vorhergehenden Ansprüche, **dadurch gekennzeichnet, dass** die Feinfraktion aus SiO₂-Nanoteilchen mit Teilchengrößen von weniger als 100 nm einen Volumenanteil der Gießhaut von mehr als 80 % ausmachen.

6. Verfahren nach einem der vorhergehenden Ansprüche, **dadurch gekennzeichnet, dass** die Innenwandung vor dem Aufbringen der Schlickerschicht befeuchtet wird, und dass ein Kokillenbasiskörper mit poröser Innenwandung eingesetzt wird.

7. Verfahren nach einem der vorhergehenden Verfahrensansprüche, **dadurch gekennzeichnet, dass** die nach dem Trocknen der Schlickerschicht erhaltene Grünschicht eine Schichtstärke im Bereich von 0,1 bis 1,5 mm, vorzugsweise im Bereich von 0,5 bis 1,5 mm, und besonders bevorzugt im Bereich von 0,7 bis 1,0 mm, aufweist.

8. Solarkokille mit Rechteckform zum Einsatz in einem Kristallzüchtungsprozess, mit einem eine Innenwandung aufweisenden Kokillenbasiskörper aus Quarzglas oder aus Quarzgut sowie einer die Innenwandung mindestens teilweise bedeckenden SiO₂- haltigen Schicht, **dadurch gekennzeichnet, dass** die SiO₂-haltige Schicht als Körnungsschicht ausgebildet ist, die amorphe SiO₂-Teilchen enthält, die eine Grobfraktion mit Teilchengrößen im Bereich zwischen 1 µm bis 50 µm sowie eine Feinfraktion aus SiO₂-Nanoteilchen mit Teilchengrößen von weniger als 100 nm bilden,
• wobei der Gewichtsanteil der SiO₂-Nanoteilchen an der Körnungsschicht im Bereich zwischen 2 bis 15 Gew.-% liegt;
• und wobei die Feinfraktion innerhalb eines oberflächennahen Volumenbereichs der Körnungsschicht, nämlich einer Gießhaut, derart angereichert ist, dass SiO₂-Nanoteilchen einen Volumenanteil von mehr als 70 % ausmachen.

9. Solarkokille nach Anspruch 8, **dadurch gekennzeichnet, dass** die Feinfraktion innerhalb eines oberflächennahen Volumenbereichs der Körnungsschicht derart angereichert ist, dass SiO₂-Nanoteilchen einen Volumenanteil von mehr als 80 % ausmachen.

10. Solarkokille nach einem der Ansprüche 8 oder 9, **dadurch gekennzeichnet, dass** die SiO₂-Körnungsschicht aus synthetisch erzeugtem Quarzglas besteht, das einen Hydroxylgruppengehalt von mindestens 50 Gew.-ppm aufweist.

11. Verfahren zur Herstellung eines Siliziumblocks in einem Kristallzüchtungsprozess durch Bereitstellen einer Solarkokille nach einem der Ansprüche 8 bis 10 mit einem eine Innenwandung aufweisenden Kokillenbasiskörper aus Quarzglas oder aus Quarzgut, von der mindestens ein Teil von einer SiO₂-haltigen Körnungsschicht bedeckt ist, wobei Silizium in die Solarkokille gefüllt, das Silizium unter Bildung einer Silizium-Schmelze erhitzt und die Silizium-Schmelze unter Kristallisation und Bildung des Siliziumblocks abgekühlt werden, **dadurch gekennzeichnet, dass** eine Solarkokille eingesetzt wird, bei der die Körnungsschicht amorphe SiO₂-Teilchen enthält, die eine Grobfraktion mit Teilchengrößen im Bereich zwischen 1 µm bis 50 µm sowie eine Feinfraktion aus SiO₂-Nanoteilchen mit Teilchengrößen von weniger als 100 nm bilden, wobei der Gewichtsanteil der SiO₂-Nanoteilchen an der Körnungsschicht im Bereich zwischen 2 bis 15 Gew.-% liegt, wobei die Feinfraktion aus SiO₂-Nanoteilchen mit Teilchengrößen von weniger als 100 nm innerhalb eines oberflächennahen Volumenbereichs der Körnungsschicht, nämlich einer Gießhaut, derart angereichert ist, dass die SiO₂-Nanoteilchen einen Volumenanteil von mehr als 70 % ausmachen, und dass die SiO₂-haltige Körnungsschicht beim Aufheizen des Siliziums thermisch verdichtet wird.

12. Verfahren nach Anspruch 11, **dadurch gekennzeichnet, dass** bevor sich die Siliziumschmelze bildet die Körnungsschicht eine Dichte von mehr als 90%, bevorzugt 93 %, ihrer theoretischen Dichte erreicht hat.

## Claims

1. A method for producing a solar crucible with a rectangular shape for use in a crystal growing process for silicon, the method comprising:
providing a crucible base body of transparent or opaque fused silica comprising an inner wall,
providing a dispersion containing amorphous SiO₂ particles;
applying a SiO₂-containing slip layer with a layer thickness of at least 0.1 mm to at least a part of the inner wall by using the dispersion;
drying the slip layer so as to form a SiO₂-containing grain layer and thermally densifying the SiO₂-containing grain layer so as to form a diffusion barrier layer, **characterized in that**
(a) the dispersion contains a dispersion liquid and the amorphous SiO₂ particles that form a coarse fraction with particle sizes in the range between 1 µm and 50 µm and a fine fraction with SiO₂ nanoparticles with particle sizes of less than 100 nm,
• wherein a weight percentage of the SiO₂ nanoparticles based on a solids content of the dispersion is in the range between 2 and 15% by wt., and
• wherein the fine fraction consisting of SiO₂ nanoparticles with particle sizes of less than 100 nm accounts for a volume proportion of the casting skin of more than 70%, and
(b) and wherein the SiO₂-containing grain layer is thermally densified into the diffusion barrier layer through the heating up of the silicon in the crystal growing process.

2. The method according to claim 1, **characterized in that** the solids content of the dispersion is less than 80% by wt., preferably between 70 and 80% by wt. and particularly preferably between 74 and 78% by wt.

3. The method according to any one of the preceding claims, **characterized in that** the dispersion is free of binders, wherein the SiO₂ content of the amorphous SiO₂ particles is at least 99.99% by wt., and wherein the total content of metallic impurities of the transition elements is less than 5 wt. ppm particularly preferably less than 2.5 wt. ppm, and the content of iron is less than 2 wt. ppm., preferably less than 1 wt. ppm, and particularly preferably less than 0.5 wt. ppm.

4. The method according to any one of the preceding claims, **characterized in that** the slip layer is applied by casting or spraying the dispersion onto the inner wall.

5. The method according to any one of the preceding claims, **characterized in that** the fine fraction consisting of SiO₂ nanoparticles with particle sizes of less than 100 nm accounts for a volume proportion of the casting skin of more than 80%.

6. The method according to any one of the preceding claims, **characterized in that** the inner wall is moistened prior to the application of the slip layer, and wherein the inner wall of the crucible base body is a with porous inner wall.

7. The method according to any one of the preceding claims, **characterized in that** a green layer obtained after drying of the slip layer has a layer thickness in the range of 0.1 - 1.5 mm, preferably in the range of 0.5-1.5 mm, and particularly preferably in the range of 0.7-1.0 mm.

8. A solar crucible with a rectangular shape for use in a crystal growing process, comprising a crucible base body of transparent or opaque fused silica comprising an inner wall, and a SiO₂-containing layer covering the inner wall at least in part, **characterized in that** the SiO₂-containing layer is formed as a grain layer which contains amorphous SiO₂ particles that form a coarse fraction with particle sizes in the range between 1 µm to 50 µm and a fine fraction of SiO₂ nanoparticles with particle sizes of less than 100 nm,
• wherein the weight percentage of the SiO₂ nanoparticles on the grain layer is in the range between 2 and 15% by wt.,
• and wherein the fine fraction within a near-surface volume portion of the grain layer, namely a casting skin, is enriched such that SiO₂ nanoparticles account for a volume proportion of more than 70%.

9. The solar crucible according to claim 8, **characterized in that** the fine fraction within a near-surface volume portion of the grain layer is enriched such that SiO₂ nanoparticles account for a volume proportion of more than 80%.

10. The solar crucible according to any one of claims 8 to 9, **characterized in that** the SiO₂ grain layer consists of synthetically produced transparent fused silica glass having a hydroxyl group content of at least 50 wt. ppm.

11. A method for producing a silicon block in a crystal growing process comprising: providing a solar crucible according to one of the claims 8 to 10 with a crucible base body of transparent or opaque fused silica comprising an inner wall, of which at least a part is covered by a SiO₂-containing grain layer; and
filling the solar crucible with silicon being, the silicon being heated so as to form a silicon melt, the silicon melt being cooled down with crystallization and formation of the silicon block,
**characterized in that** the SiO₂-containing grain layer contains amorphous SiO₂ particles that form a coarse fraction with particle sizes in the range between 1 µm and 50 µm and a fine fraction of SiO₂ nanoparticles with particle sizes of less than 100 nm,
wherein the weight percentage of the SiO₂ nanoparticles of the SiO₂-containing grain layer is in the range between 2 and 15% by wt.,
and wherein the fine fraction consisting of SiO₂ nanoparticles with particle sizes of less than 100 nm within a near-surface volume portion of the grain layer, namely a casting skin, is enriched such that SiO₂ nanoparticles account for a volume proportion of more than 70%, and
wherein the SiO₂-containing grain layer is thermally densified during heating up of the silicon.

12. The method according to claim 11, **characterized in that** before the formation of the silicon melt, the SiO₂-containing grain layer has reached a density of more than 90% of its theoretical density.

## Revendications

1. Procédé pour la fabrication d'une lingotière solaire de forme rectangulaire destinée à être utilisée dans un processus de cristallogenèse de silicium, dans lequel un corps de base de lingotière en verre de quartz ou en quartz doté d'une paroi intérieure ainsi qu'une dispersion contenant des particules amorphes de SiO₂ sont préparés, une couche de barbotine contenant du SiO₂ d'une épaisseur de couche d'au moins 0,1 mm est appliquée sur au moins une partie de la paroi intérieure en utilisant la dispersion, et la couche de barbotine est séchée et comprimée thermiquement afin de former une couche de barrière de diffusion, **caractérisé en ce que**
(a) la dispersion contient un liquide de dispersion et des particules amorphes de SiO₂, qui forment une fraction grossière avec des tailles de particule comprises entre 1 µm et 50 µm ainsi qu'une fraction fine avec des nanoparticules de SiO₂ présentant des tailles de particule inférieures à 100 nm,
• la part en poids des nanoparticules de SiO₂ par rapport à la teneur en matières solides de la dispersion étant comprise dans la plage allant de 2 à 15 % en poids, et
• la fraction fine de nanoparticules de SiO₂ avec des tailles de particule inférieures à 100 nm représentent une fraction volumique d'une peau de coulage de plus de 70 %,
(b) et **en ce que** la couche de matériau granulaire contenant du SiO₂ est comprimée thermiquement pour former la couche de barrière de diffusion uniquement par le chauffage du silicium lors du processus de cristallogenèse.

2. Procédé selon la revendication 1, **caractérisé en ce que** la teneur en matières solides de la dispersion est inférieure à 80 % en poids, de préférence est comprise entre 70 et 80 % en poids, et de manière particulièrement préférée est comprise entre 74 et 78 % en poids.

3. Procédé selon l'une des revendications précédentes, **caractérisé en ce que** la dispersion est exempte de liant et **en ce que** la teneur en SiO₂ des particules amorphes de SiO₂ est d'au moins 99,99 % en poids, la teneur totale en impuretés métalliques des éléments de transition étant inférieure à 5 ppm en poids, de manière particulièrement préférée inférieure à 2,5 ppm en poids et la teneur en fer étant inférieure à 2 ppm en poids, de préférence inférieure à 1 ppm en poids et de manière particulièrement préférée inférieure à 0,5 ppm en poids.

4. Procédé selon l'une des revendications précédentes, **caractérisé en ce que** la couche de barbotine est appliquée par versement ou projection de la dispersion sur la paroi intérieure.

5. Procédé selon l'une des revendications précédentes, **caractérisé en ce que** la fraction fine en nanoparticules de SiO₂ avec des tailles de particule inférieures à 100 nm constitue une fraction volumique de la peau de coulage de plus de 80 %.

6. Procédé selon l'une des revendications précédentes, **caractérisé en ce que** la paroi intérieure est humidifiée avant l'application de la couche de barbotine, et **en ce qu'**un corps de base de lingotière à paroi intérieure poreuse est utilisé.

7. Procédé selon l'une des revendications de procédé précédentes, **caractérisé en ce que** la couche crue obtenue après le séchage de la couche de barbotine présente une épaisseur de couche comprise entre 0,1 et 1,5 mm, de préférence comprise entre 0,5 et 1,5 mm, et de manière particulièrement préférée comprise entre 0,7 et 1,0 mm.

8. Lingotière solaire de forme rectangulaire destinée à être utilisée dans un processus de cristallogenèse, comprenant un corps de base de lingotière en verre de quartz ou en matériau de quartz doté d'une paroi intérieure ainsi qu'une couche contenant du SiO₂ recouvrant au moins partiellement la paroi intérieure, **caractérisée en ce que** la couche contenant du SiO₂ est réalisée sous la forme d'une couche de matériau granulaire, qui contient des particules amorphes en SiO₂, qui forment une fraction grossière avec des tailles de particule comprises entre 1 µm et 50 µm ainsi qu'une fraction fine en nanoparticules de SiO₂ avec des tailles de particule inférieures à 100 nm,
• la part en poids des nanoparticules de SiO₂ dans la couche de matériau granulaire étant comprise dans la plage allant de 2 à 15 % en poids ;
• et la fraction fine dans une zone volumique proche de la surface de la couche de matériau granulaire, à savoir une peau de coulage, étant enrichie de telle manière que des nanoparticules de SiO₂ représentent une fraction volumique de plus de 70 %.

9. Lingotière solaire selon la revendication 8, **caractérisée en ce que** la fraction fine dans une zone volumique proche de la surface de la couche de matériau granulaire est enrichie de telle manière que des nanoparticules de SiO₂ représentent une fraction volumique de plus de 80 %.

10. Lingotière solaire selon l'une des revendications 8 et 9, **caractérisée en ce que** la couche de matériau granulaire en SiO₂ consiste en du verre de quartz produit de manière synthétique, qui présente une teneur en groupes hydroxy d'au moins 50 ppm en poids.

11. Procédé pour la fabrication d'un bloc de silicium dans un processus de cristallogenèse par la préparation d'une lingotière solaire selon l'une des revendications 8 à 10, comprenant un corps de base de lingotière en verre de quartz ou en quartz doté d'une paroi intérieure, dont au moins une partie est recouverte par une couche de matériau granulaire contenant du SiO₂, du silicium étant rempli dans la lingotière solaire, le silicium étant chauffé pour former une masse fondue de silicium et la masse fondue de silicium étant refroidie en cristallisant et en formant le bloc de silicium, **caractérisé en ce qu'**une lingotière solaire est utilisée, dans laquelle la couche de matériau granulaire contient des particules amorphes de SiO₂, qui forment une fraction grossière avec des tailles de particule comprises entre 1 µm et 50 µm ainsi qu'une fraction fine de nanoparticules de SiO₂ avec des tailles de particule inférieures à 100 nm, la part en poids des nanoparticules de SiO₂ dans la couche de matériau granulaire étant comprise dans la plage allant de 2 à 15 % en poids, la fraction fine en nanoparticules de SiO₂ avec des tailles de particule inférieures à 100 nm dans une zone volumique proche de la surface de la couche de matériau granulaire, à savoir une peau de coulage, étant enrichie de telle manière que les nanoparticules de SiO₂ représentent une fraction volumique de plus de 70 %, et **en ce que** la couche de matériau granulaire contenant du SiO₂ est comprimée thermiquement lors du chauffage du silicium.

12. Procédé selon la revendication 11, **caractérisé en ce que** la couche de matériau granulaire a atteint une densité de plus de 90 %, de préférence 93 %, de sa densité théorique avant que la masse fondue de silicium se forme.
